# EUROPÄISCHE PATENTSCHRIFT

(11) **EP 3 715 496 B1**
(45) Veröffentlichungstag und Bekanntmachung des Hinweises auf die Patenterteilung: **17.07.2024**
(21) Anmeldenummer: 19166312.9
(22) Anmeldetag: 29.03.2019
(51) Int. Cl.: C23C 14/08, C23C 14/34, H01J 37/34

(54) **SPUTTERINGTARGET ZUR HERSTELLUNG MOLYBDÄNOXIDHALTIGER SCHICHTEN**
SPUTTERING TARGET FOR PRODUCING LAYERS CONTAINING MOLYBDENUM OXIDE
CIBLE DE PULVÉRISATION DESTINÉE À LA FABRICATION DE COUCHES CONTENANT DE L'OXYDE DE MOLYBDÈNE

(43) Veröffentlichungstag der Anmeldung: 30.09.2020
(73) Patentinhaber: Plansee SE, 6600 Reutte (AT)
(72) Erfinder: O`SULLIVAN, Michael, 6600 Reutte (AT); WINKLER, Jörg, 6600 Reutte (AT); FRANZKE, Enrico, 6600 Reutte (AT); LINKE, Christian, 6600 Reutte (AT); SCHERER, Thomas, 6600 Reutte (AT)
(74) Vertreter: Ciesla, Bettina

(56) Entgegenhaltungen:
- DE-A1- 102012 112 739
- DE-A1- 102014 111 935
- PACHLHOFER JULIA M ET AL: "Non-reactive dc magnetron sputter deposition of Mo-O thin films from ceramic MoOxtargets", SURFACE AND COATINGS TECHNOLOGY, vol. 332, 18 September 2017 (2017-09-18), pages 80 - 85, XP085293368, ISSN: 0257-8972, DOI: 10.1016/J.SURFCOAT.2017.07.083

## Beschreibung

Die vorliegende Erfindung betrifft ein Sputteringtarget zur Herstellung molybdänoxidhaltiger Schichten sowie die Verwendung solch eines Sputteringtargets zur Gasphasen-Abscheidung einer molybdänoxidhaltigen Schicht.

Molybdänoxidhaltige Schichten (insbesondere auf Basis von Molybdänoxid) haben interessante optische Eigenschaften und finden deshalb insbesondere Anwendung bei Schichtstrukturen in optischen bzw. optoelektronischen Applikationen wie beispielsweise elektronischen Displays. Ihre Anwendung erfolgt häufig in Kombination mit bzw. direkt angrenzend zu metallischen Schichten aus z.B. Aluminium (Al), Kupfer (Cu), Titan (Ti), oder (metallischem) Molybdän (Mo), die z.B. als elektrische Leiterbahnen fungieren. Ein Anwendungsbeispiel von Molybdänoxidschichten ist JP 2013020347 A zu entnehmen, in der metallische Leiterbahnen innerhalb des Displays eines kapazitiven Berührungssensors (Engl.: touch screen) durch eine lichtabsorbierende Schicht aus MoOx abgedeckt werden, um unerwünschte Reflexionen der metallischen Leiterbahnen zu unterdrücken.

Wichtige Eigenschaften wie Lichtabsorptions-, Lichtreflexions-, Lichttransmissionsgrad, Ätzrate, thermische Stabilität sowie Stabilität gegenüber weiteren im Fertigungsprozess eingesetzten Chemikalien (z.B. Fotolack-Entwickler bzw. -Entferner), hängen von der genauen stöchiometrischen Zusammensetzung der abgeschiedenen molybdänoxidhaltigen Schicht sowie den zugefügten Dotierungselementen (z.B. Ta, Nb, etc.) ab. Die Ätzrate ist dabei relevant bei anschließender Strukturierung der abgeschiedenen Schicht mittels Fotolithographie in Verbindung mit einem nasschemischen Ätzprozess. So werden in vielen Anwendungen, wie beispielsweise bei dem oben genannten kapazitiven Berührungssensor, molybdänoxidhaltige Schichten gefordert, in denen das Oxid (Molybdänoxid und/oder ein molybdänhaltiges Mischoxid) in einer substöchiometrischen Zusammensetzung vorliegt, d.h. das Oxid hat unbesetzte Sauerstoff-Valenzen und es liegen in der abgeschiedenen molybdänoxidhaltigen Schicht Sauerstofffehlstellen vor. In solchen substöchiometrischen molybdänoxidhaltigen Schichten (insbesondere auf Basis von Molybdänoxid) können interessante elektro-optische Eigenschaften erzielt werden, wie beispielsweise eine hohe Lichtabsorption (und korrespondierend damit eine niedrige Lichtreflektion) im sichtbaren Wellenlängenbereich, insbesondere bei einer Referenzwellenlänge von 550 nm, und gleichzeitig eine ausreichende elektrische Leitfähigkeit (insbesondere von einem Flächenwiderstand < 20 kΩ/□ bzw. < 20 kΩ/Square). Reine Molybdänoxid-Schichten haben zwar attraktive elektro-optische Eigenschaften, sie weisen jedoch in der Regel in gängigen Nassätzmedien (z.B. PAN-Ätze auf der Basis von Phosphorsäure, Salpetersäure und Essigsäure zum Strukturieren von Aluminium-Metallisierungen, Ätze auf H₂O₂-Basis zum Strukturieren von Cu) eine zu hohe Ätzrate auf, was zu instabilen Ätzergebnissen führt. Durch die Zugabe von Dotierungselementen in die substöchiometrische molybdänoxidhaltige Schicht (und entsprechend in das Targetmaterial des Sputteringtargets), wie z.B. von Ta und/oder Nb, kann die Ätzrate auf ein akzeptables Niveau abgesenkt werden, ohne dass sich die elektro-optischen Eigenschaften erheblich ändern.

Derartige molybdänoxidhaltige Schichten (insbesondere auf Basis von Molybdänoxid) werden industriell in einem Beschichtungsprozess mittels Kathodenzerstäubung ("Sputtern") hergestellt. Grundsätzlich ist es zwar möglich, solche molybdänoxidhaltigen Schichten durch reaktives Sputtern eines metallischen Targetmaterials, das z.B. in einer entsprechend eingestellten Argon- und Sauerstoff-Prozessgasatmosphäre reaktiv gesputtert wird, herzustellen. Die Metallatome des Targetmaterials reagieren dabei zu einem hohen Anteil erst während des Beschichtungsprozesses mit dem Sauerstoff aus dem Prozessgas, so dass die Prozessführung durch Hystereseeffekte (diskontinuierliche Änderungen der Schichtabscheiderate, des Entladungsstromes und/oder der Targetspannung aufgrund von Änderungen des Sauerstoffpartialdruckes) und Vergiftung der Targetoberfläche (Engl. target poisoning) erschwert wird. Demgegenüber ist die Abscheidung von einem Sputteringtarget mit oxidischem Targetmaterial unter industriellen Bedingungen vorteilhaft, da der Beschichtungsprozess entweder mit einem reinen Edelgas-Prozessgas (in der Regel Argon) oder mit Edelgas (in der Regel Argon) als Hauptbestandteil, dem geringe Mengen weiterer Gase, wie z.B. Sauerstoff, zugesetzt sind, durchgeführt werden kann. Insbesondere werden beim Einsatz oxidischen Targetmaterials höhere Beschichtungsraten und eine höhere Prozessstabilität unter gleichzeitiger Vereinfachung der Prozessführung ermöglicht. Des Weiteren sind viele bereits installierte Beschichtungsanlagen lediglich für das Abscheiden von metallischen Schichten von einem metallischen Sputteringtarget ausgelegt und erlauben deshalb nicht die Zudosierung von Sauerstoff in das Sputtergas. Die Vielseitigkeit solcher einsetzbaren Sputteranlagen kann durch den Einsatz eines oxidischen Targetmaterials erhöht werden.

Die DE 10 2012 112 739 A1 beschreibt ein substöchiometrisches Targetmaterial, bei dem ein Sauerstoffmangel entweder durch eine reduzierte Oxidphase von substöchiometrischem und dadurch elektrisch leitfähigem Oxid oder Oxinitrid auf der Basis von Nb₂O_{5-y}, TiO_{2-y}, MoO_{3-y}, WO_{3-y}, V₂O_{5-y} (y>0) oder deren Mischungen allein oder durch die reduzierte Oxidphase zusammen mit einer metallischen Beimischung eingestellt wird. In der US 2001/0020586 A1 ist ein substöchiometrisches Targetmaterial der chemischen Zusammensetzung MOy beschrieben, bei dem M mindestens ein Metall aus der Gruppe Ti, Nb, Ta, Mo, W, Zr und Hf ist.

Das Dokument DE 10 2014 111935 A1 beschreibt ein Sputteringtarget, das eine Mischung aus verschiedenen substöchiometrischen Metalloxiden verschiedener Metalle wie Mo, W, Nb, Ti, Ta, V usw. enthält.

Losgelöst von den oben genannten Herausforderungen und Rahmenbedingungen bezüglich molybdänoxidhaltiger Schichten und entsprechender Targetmaterialien ist in wissenschaftlichen Veröffentlichungen die Herstellung pulverförmiger, molybdänhaltiger Mischoxidverbindungen im labortechnischen Maßstab (d.h. Produktmengen von wenigen Gramm) mit Haltezeiten bei erhöhten Temperaturen von einer oder mehreren Wochen beschrieben. So beschreiben zum Beispiel Ekström und Nygren (Thommy Ekström and Mats Nygren, Acta Chemica Scandinavica 26 (1972) 1836-1842) die Synthese von (Mo₁₋ₓTaₓ)₆O₁₄ in einem Homogenitätsbereich von 0,06 ≤ x ≤ 0,08 durch Mischen von Ta₂O₅-Pulver mit MoOs und MoO₂, Einfüllen der Pulvermischung in Quarzampullen, Evakuieren der Quarzampullen und Aufheizen auf 640 - 750°C für eine Zeitdauer von einer bis mehrere Wochen. In der gleichen Veröffentlichung wird auch die Synthese von (Mo₁₋ₓNbₓ)₅O₁₄ in einem Homogenitätsbereich von 0,07 ≤ x ≤ 0,12 beschrieben. Ausgangspulver waren Nb₂O₅, MoOs und MoO₂, die Synthesebedingungen waren analog wie bei (Mo₁₋ₓTaₓ)₅O₁₄, allerdings wurde das Mischoxid in einem Temperaturbereich von 600 - 750 °C erhalten. Ekström und Nygren beschreiben in einer weiteren Veröffentlichung (Thommy Ekström and Mats Nygren, Acta Chemica Scandinavica 26 (1972) 1827-1835) auch die Synthese von (Mo₁₋ₓVₓ)₅O₁₄, welches aus einer Pulvermischung von V₂O₅ mit MoOs und MoO₂ analog den bereits beschrieben Mischoxiden hergestellt wurde, wobei ein breiter Homogenitätsbereich von 0,02 ≤ x ≤ 0,11 bei einem Aufheizen auf 640°C bzw. von 0,05 ≤ x ≤ 0,11 bei einem Aufheizen auf 750°C beobachtet wurde. Auch die Synthese von (Mo₁₋ₓTiₓ)₅O₁₄ mit einem Homogenitätsbereich von 0,03 ≤ x ≤ 0,05 wurde von Ekström bereits beschrieben (Thommy Ekström, Acta Chemica Scandinavica 26 (1972) 1843-1846), wobei die Herstellung aus einer Pulvermischung von TiO₂, MoO₂ und MoOs analog den bereits beschriebenen Mischoxiden mit einem Aufheizen auf eine Temperatur von 600 bis 750°C erfolgte. Bei sämtlichen Synthesen wurde das Produkt lediglich in geringen Mengen (Gramm-Maßstab) in loser Pulverform, nicht als solider makroskopischer Festkörper, erhalten.

Dementsprechend besteht die Aufgabe der vorliegenden Erfindung darin, dotierte molybdänoxidhaltige Sputteringtargets bereitzustellen, bei denen ein stabiler Sputterprozess zur Herstellung qualitativ hochwertiger Schichten einstellbar ist, wobei die Sputteringtargets kostengünstig und prozesssicher in industriellem Maßstab herstellbar sein sollen.

Die Aufgabe wird gelöst durch ein Sputteringtarget gemäß Anspruch 1 sowie durch eine Verwendung eines Sputteringtargets gemäß Anspruch 9. Vorteilhafte Weiterbildungen der Erfindung sind in den abhängigen Ansprüchen angegeben.

Gemäß der vorliegenden Erfindung wird ein Sputteringtarget mit einem elektrisch leitfähigen, oxidischen Targetmaterial bereitgestellt. Das Targetmaterial besteht dabei mindestens aus einem Metalloxid
- von Molybdän (Mo) als metallischem Hauptbestandteil und
- von mindestens einem Dotierungselement M aus der Gruppe Tantal (Ta), Niob (Nb), Vanadium (V) und Titan (Ti).

Das Targetmaterial weist dabei - bezogen auf ein Schliffbild desselben und gemessen mit einem Raman-Mikroskop (mittels Raman-Spektroskopie) - eine Matrixphase aus einem Mischoxid (Mo₁₋ₓMₓ)₅O₁₄ mit 0,01 ≤ x ≤ 0,13 auf, wobei M in diesem Mischoxid eines oder mehrere Elemente der Gruppe Tantal (Ta), Niob (Nb), Vanadium (V) und Titan (Ti) ist.

Der vorliegenden Erfindung liegt dabei die Erkenntnis zugrunde, dass es im Hinblick auf die Prozessstabilität des Sputterprozesses vorteilhaft ist, wenn der Sauerstoffgehalt des Targetmaterials identisch oder im Wesentlichen identisch zu demjenigen der herzustellenden Schicht ist. Vorzugsweise weichen der Sauerstoffgehalt (Gew.%) des Targetmaterials und der Sauerstoffgehalt (Gew.%) der herzustellenden Schicht um maximal ± 2 Gew.% voneinander ab. Eine Zuführung von Sauerstoff über das Prozessgas ist damit nicht oder nur zu einem geringen Anteil erforderlich, wodurch Hystereseeffekte unterdrückt und die Prozessführung vereinfacht werden.

Ferner ist zu berücksichtigen, dass grundsätzlich eine Vielzahl von Phasenzusammensetzungen eines dotierten, molybdänoxidhaltigen Targetmaterials möglich sind. Zum einen kann Molybdän in unterschiedlichen Oxidationsstufen vorliegen, insbesondere in Form von MoO₂, von MoO₃, sowie in Form einer Mehrzahl von substöchiometrischen Oxiden MoO_{y}, wie z.B. Mo₄O₁₁ (y=2,75), Mo₁₇O₄₇ (y=2,76), Mo₆O₁₄ (y=2,8), Mo₃O₂₃ (y=2,875), Mo₉O₂₆ (y=2,89) und Mo₁₈O₅₂ (y=2,89), wobei Mo₉O₂₆ die Hochtemperaturmodifikation und Mo₁₈O₅₂ die Tieftemperaturmodifikation bildet. Erfindungsgemäß ist vorgesehen, dass das mindestens eine Dotierungselement M in dem Targetmaterial enthalten ist. Bezüglich der möglichen Phasenzusammensetzungen des Targetmaterials kommen hierdurch weitere Freiheitsgrade hinzu, denn das mindestens Dotierungselement M kann grundsätzlich elementar in dem Target (d.h. in metallischer Form, z.B. als Ta, Nb, V, Ti) vorliegen, es kann als Oxid vorliegen (z.B. Ta₂O₅, V₂O₅, Nb₂O₅, TiO₂), es kann als substöchiometrisches Oxid vorliegen sowie ferner kann es ein Mischoxid mit einem oder mehreren der oben genannten Molybdänoxide und/oder mit einem oder mehreren Oxiden des mindestens eines weiteren Dotierungselements M bilden. Im Hinblick auf die Vielzahl an möglichen Phasenzusammensetzungen liegt der vorliegenden Erfindung die Erkenntnis zugrunde, dass unterschiedliche Phasen des Targetmaterials, insbesondere wenn sie teilweise isolierend oder dielektrisch sind, zu Partikelbildung durch Ausbildung von Lichtbögen (Arcs) beim Sputtern führen können. In Folge dessen kann es zu Schichtfehlern oder Beschädigung des Sputteringtargets kommen. Weiterhin ist die Festigkeit von oxidischen Targets eher gering, vor allem wenn die Mikrostruktur mehrere unterschiedliche, ungleichmäßig verteilte, grobe und/oder poröse Phasen aufweist. Besonders kritisch im Hinblick auf die Festigkeit ist es, wenn Phasen unterschiedliche Dichten oder CTE's (CTE: coefficient of thermal expansion; thermischer Ausdehnungskoeffizient) haben und/oder aneinander angrenzende Phasen aufgrund von z.B. Diffusionsporen, unterschiedlichen Gittertypen, etc., nicht ausreichend fest miteinander verbunden sind. Verschiedene Phasen weisen teilweise auch unterschiedliche Sputterraten auf, wodurch gerade bei mehreren, ungleichmäßig verteilten, groben und porösen Phasen des Targetmaterials die Schichthomogenität und die Schichtstöchiometrie der hergestellten Schichten unzureichend sein können. Teilweise sind die Phasen (z.B. MoOs) bedingt wasserlöslich, wodurch es beim Herstellprozess (z.B. mechanische Bearbeitung, Reinigung) zu Änderungen der Stöchiometrie im Oberflächenbereich und/oder zur Einlagerung von Restfeuchtigkeit kommen kann, was sich wiederum negativ auf den Sputterprozess sowie die hergestellte Schicht auswirken kann (z.B. Beeinträchtigung des Vakuums, Einlagerung von H₂O in die Schicht).

Demgegenüber wurde festgestellt, dass die erfindungsgemäß vorgesehene (Mo₁₋ₓMₓ)₅O₁₄-Mischoxidphase mit 0,01 ≤ x ≤ 0,13 in dem Targetmaterial besonders vorteilhaft ist, da sie elektrisch leitfähig ist, keine Wasserlöslichkeit aufweist und unter Umgebungsbedingungen stabil ist. Weiterhin ist dadurch auch das Dotierungselement M (zumindest anteilig) in dieser Matrixphase und damit in einer elektrisch leitfähigen Phase gebunden und gleichmäßig über das Targetmaterial verteilt. Indem diese Mischoxidphase erfindungsgemäß die Matrixphase bildet, in der gegebenenfalls vorhandene Zweitphasen (vorzugsweise feinverteilt) eingelagert sein können, nimmt sie einen erheblichen und durch das Sputteringtarget hindurchgehenden Anteil des Targetmaterials ein, wodurch das gesamte Targetmaterial mit diesen vorteilhaften Eigenschaften geprägt wird. Zum Beispiel ist damit eine elektrische Leitfähigkeit durch das gesamte Targetmaterial hindurch gegeben und ein Kontakt mit Wasser ist relativ unkritisch, da die Matrix hierdurch nicht angegriffen wird. Wie oberhalb erläutert wird, sind diese Eigenschaften vorteilhaft im Hinblick auf eine gleichmäßige Sputterrate, auf die Vermeidung von Lichtbögen (Arcs) und Partikelbildung, auf eine homogene Schichtzusammensetzung und eine gleichmäßige Schichtdicke, auf eine stabile Prozessführung während des Sputterprozesses sowie im Hinblick auf eine einfache Herstellung, Aufbewahrung und Handhabung des Sputteringtargets. Weiterhin vorteilhaft ist, dass das erfindungsgemäße Sputteringtarget in industriellem Maßstab als kompaktes Bauteil (kompaktes Targetmaterial von z.B. mindestens 1 kg pro Targetsegment) mit hoher relativer Dichte und hoher Phasenreinheit innerhalb kurzer Prozesszeiten (z.B. Haltezeiten typischerweise < 12 Stunden) herstellbar ist, wie nachstehend noch im Detail beschrieben wird.

Das "Sputtern", auch Kathodenzerstäubung genannt, ist ein physikalischer Vorgang, bei dem Atome oder Moleküle aus einem Festkörper (Targetmaterial) durch Beschuss mit energiereichen Ionen (z.B. Edelgasionen des Prozessgases) herausgelöst werden und in die Gasphase übergehen. Zur Herstellung dünner Schichten wird das zerstäubte Targetmaterial auf einem Substrat abgeschieden und bildet dort eine feste Schicht aus. Dieser zum Teil auch als Sputterdeposition bezeichnete Beschichtungsvorgang zählt zu den PVD-Verfahren (PVD: physical vapour deposition; physikalische Gasphasenabscheidung) und wird nachfolgend ebenfalls als "Sputtern" bezeichnet. Als Targetmaterial wird dasjenige als Festkörper vorliegende Material eines Sputteringtargets bezeichnet, das für die Zerstäubung während des Sputterprozesses und für die Schichtbildung (ggf. gemeinsam mit weiteren Materialien aus dem Prozessgas und/oder von weiteren Sputteringtargets) vorgesehen ist. Das Sputteringtarget kann ausschließlich durch das Targetmaterial gebildet werden oder darüber hinaus auch noch weitere, mit dem Targetmaterial direkt oder mittelbar (d.h. über mindestens ein weiteres Bauteil) verbundene Bauteile aufweisen, wie z.B. Rückplatte(n), Trägerrohr(e), Anschlussstück(e), Einsätz(e). Das Sputteringtarget (und entsprechend das Targetmaterial) kann dabei in unterschiedlichen Geometrien bereitgestellt werden, insbesondere als planares Sputteringtarget mit unterschiedlichen Grundformen, wie z.B. quadratisch, rechteckig, rund, etc., oder auch als rohrförmiges Sputteringtarget. Das Targetmaterial bildet insbesondere einen makroskopischen Festkörper mit einer Ausdehnung entlang mindestens einer Raumrichtung von mindestens 0,03 m (Meter).

Unter einem "oxidischen" Targetmaterial wird verstanden, dass die in dem Targetmaterial enthaltenen Metalle im Wesentlichen vollständig als Oxide vorliegen. Insbesondere ist in dem Targetmaterial der Anteil an metallischen Phasen bezogen auf ein Schliffbild desselben < 1 Vol.%. Insbesondere ist der Anteil an metallischen Phasen in dem Targetmaterial unterhalb der Nachweisgrenze mittels der hier angewandten und nachstehend noch näher beschriebenen Raman-Messungen. Als "elektrisch leitfähig" wird das Targetmaterial dann bezeichnet, wenn es eine elektrische Leitfähigkeit von mindestens 80 S/m aufweist, gemessen über einen Widerstands-Messstand (Ulvac ZEM3) mit der 4-Punkt-Messmethode. Als "Phase" des Targetmaterials wird ein räumlicher Bereich desselben verstanden, innerhalb dessen eine einheitliche chemische Zusammensetzung und eine einheitliche Kristallstruktur gegeben ist, wobei die Ausrichtung der einzelnen Kristallkörner innerhalb einer Phase unterschiedlich sein kann. Als "Mischoxid" wird ein Oxid mit einer Kristallstruktur verstanden, bei dem sich das Kristallgitter aus Sauerstoffionen sowie Kationen mehrerer Elemente (vorliegend insbesondere von Mo und mindestens ein Dotierungselement M) zusammensetzt. Unter einer "Matrixphase" wird vorliegend verstanden, dass diese das Targetmaterial in einem zusammenhängenden, perkolierenden Netzwerk durchzieht, in das ggf. vorhandene weitere Phasen ("Zweitphasen") als inselförmige Bereiche eingebettet sind (zu beobachten am Schliffbild mit einem Raman-Mikroskop mittels Raman-Spektroskopie).

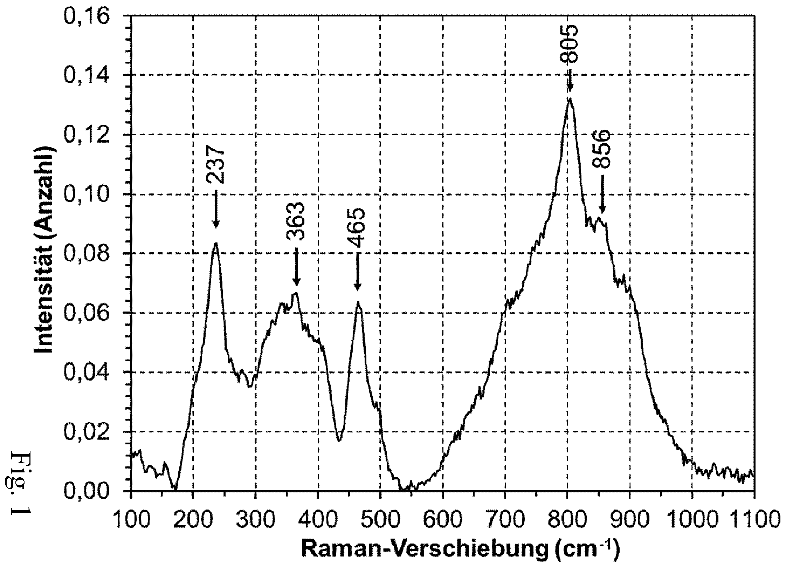

Die Bestimmung der verschiedenen Phasen und deren Volumenanteile sowie auch der Dichte des Targetmaterials erfolgen anhand eines repräsentativen Querschnitts einer Probe, wobei - da ein isotropes Gefüge angenommen werden kann - die Volumenangaben aus an der Schnittfläche gemessenen Flächenanteilen abgeleitet werden (d.h. die Volumenanteile entsprechen den gemessenen Flächenanteilen). Mittels Trockenpräparation wird hierzu ein metallographischer Schliff der Probe hergestellt, wobei zur ortsaufgelösten Bestimmung der verschiedenen Metalloxid-Phasen die Raman-Spektroskopie unter Einsatz eines Raman-Mikroskops angewendet wird. Wie nachstehend noch im Detail beschrieben ist, wird bei der Raman-Spektroskopie die zu analysierende Probenoberfläche des Targetmaterials punktweise mit einem Laserstrahl abgerastert und für jeden Messpunkt ein vollständiges Raman-Spektrum erstellt ("Raman-Mapping"). Durch Vergleich des erhaltenen Raman-Spektrums für jeden Messpunkt mit Referenzspektren von verschiedenen, in Frage kommenden Metalloxiden, wird jedem Messpunkt eine entsprechende Phase zugeordnet und so eine zweidimensionale Darstellung der Phasenzusammensetzung der Probe erstellt, aus der sich dann die Flächenanteile (bzw. die Volumenanteile) der verschiedenen Phasen berechnen lassen. Die (Mo₁₋ₓMₓ)₅O₁₄ Matrixphase kann mittels Raman-Spektroskopie eindeutig identifiziert werden. Ein Referenz-Ramanspektrum einer (Mo_{0,93}Ta_{0,07})₅O₁₄-Phase ist in Figur 1 gezeigt. Die Pulverdiffraktogrammdaten sind unter der PDF Nr. 01-070-0952 vom Internationalen Zentrum für Beugungsdaten (International Centre for Diffraction Data; ICDD) erhältlich. Die Volumenangaben (bzw. die hierzu identischen Flächenangaben) der verschiedenen Metalloxid-Phasen sind normiert und Relativangaben bezüglich des Gesamtvolumens (bzw. der Gesamtfläche), das von den materiellen Teilchen (Körnern) des Targetmaterials eingenommen wird. Das von den Poren des Targetmaterials eingenommene Volumen (bzw. die hierzu identische Fläche) ist von diesem Gesamtvolumen (bzw. dieser Gesamtfläche) ausgeklammert. Die Volumenangaben (bzw. die hierzu identischen Flächenangaben) der einzelnen Metalloxid-Phasen addieren sich daher allein ohne das Porenvolumen auf 100%.

Gemäß der vorliegenden Erfindung kann das Targetmaterial aus mehreren Metalloxiden unterschiedlicher chemischer Zusammensetzung (die dann unterschiedliche Phasen bilden), gebildet werden. Dabei kann das jeweilige Metalloxid ein stöchiometrisches oder ein substöchiometrisches Metalloxid von genau einem Metall oder alternativ von mehreren Metallen (d.h. in letzterem Fall ein Mischoxid) sein. In dem Targetmaterial bildet Mo erfindungsgemäß bzgl. der enthaltenen Metalle (die als Kationen vorliegen), den Hauptbestandteil, d.h. der Mo-Anteil (Mo; in at.%) relativ zu der Summe aller enthaltenen Metalle (Me; in at.%) einschließlich des Mo-Anteils (Mo; in at.%), d.h. Mo/(Me+Mo) beträgt mindestens 50%. Insbesondere beträgt er mindestens 80%, noch bevorzugter mindestens 84%. Grundsätzlich können neben Mo und dem mindestens einen Dotierungselement M auch noch weitere Metalle in dem Targetmaterial enthalten sein. Vorzugsweise werden jedoch die weiteren, in dem Targetmaterial neben Mo enthaltenen Metalle - abgesehen von ggf. vorhandenen Verunreinigungen - ausschließlich durch das mindestens eine Dotierungselement M gebildet. Grundsätzlich können in dem Targetmaterial zwei oder mehrere Dotierungselemente M aus der Gruppe Ta, Nb, V und Ti enthalten sein. Insbesondere ist in dem Targetmaterial aber nur genau ein Dotierungselement M aus dieser Gruppe enthalten. Bevorzugt ist dieses genau eine Dotierungselement M Ta oder alternativ Nb. Durch die Zugabe von Ta und/oder Nb als Dotierungselement kann die Naßätzrate in einem gängigen Aluminium-Ätzmittel (Mischung aus Phosphorsäure, Salpetersäure, Essigsäure und Wasser) auf ein akzeptables Maß abgesenkt werden. Auch die Naßätzrate in Kupfer-Ätzmitteln auf Basis von Wasserstoffperoxid kann durch Zugabe von Ta oder Nb beeinflusst werden. Ta bzw. Ta-Oxid-Pulver ist ein Ausgangsprodukt, das in großen Mengen verfügbar ist, jedoch starken Preisschwankungen unterliegt. Nb bzw. Nb-Oxid-Pulver ist in der Regel zu einem günstigeren Preis verfügbar.

Wie erwähnt, können in dem Targetmaterial herstellungsbedingte "Verunreinigungen" (Metalle wie auch Nichtmetalle) enthalten sein, wie z.B. Wolfram (W), Natrium (Na), Kalium (K), Antimon (Sb), Vanadium (V), Chrom (Cr), Eisen (Fe), Kohlenstoff (C) und Stickstoff (N). Der Gesamtgehalt solcher Verunreinigungen ist typischerweise < 1.000 µg/g.

Grundsätzlich werden gemäß der vorliegenden Erfindung in dem Mischoxid (Mo₁₋ₓMₓ)₅O₁₄ zwei oder mehrere Dotierungselemente M aus der Gruppe Ta, Nb, V und Ti enthalten sein. Insbesondere ist in dem Mischoxid (Mo₁₋ₓMₓ)₅O₁₄ aber nur genau ein Dotierungselement M aus dieser Gruppe enthalten. Weiterhin ist grundsätzlich gemäß der vorliegenden Erfindung möglich, dass auch mehrere unterschiedliche Mischoxide (Mo₁₋ₓMₓ)₅O₁₄, jeweils mit M als eines oder mehrere Elemente aus der Gruppe Ta, Nb, V und Ti, in dem Targetmaterial enthalten sind, wobei dann genau eines dieser Mischoxide die genannte Matrixphase bildet. Insbesondere gilt für den Bereich x innerhalb des Mischoxids (Mo₁₋ₓMₓ)₅O₁₄ der Matrixphase 0,02 ≤ x ≤ 0,12.

Gemäß der Erfindung wird das Targetmaterial durch mindestens ein Metalloxid
- von Molybdän (Mo) als metallischem Hauptbestandteil und
- von mindestens einem Dotierungselement M aus der Gruppe Tantal (Ta), Niob (Nb), Vanadium (V) und Titan (Ti)
gebildet. Dementsprechend gilt, dass - abgesehen von ggf. vorhandenen Verunreinigungen (Definition "Verunreinigungen" s. oberhalb) - keine weiteren Metalle enthalten sind und alle Metalle oxidisch gebunden sind (und nicht z.B. als Nitrid, Borid, etc., vorliegen). Hierdurch werden die vorteilhaften Eigenschaften von Molybdänoxid(en) in Kombination mit der Wirkung des mindestens einen Dotierungselements M (z.B. Beeinflussung der Naßätzrate) erzielt, ohne dass weitere, ggf. nachteilige Wechselwirkungen auftreten.

Erfindungsgemäss weist in dem Targetmaterial die Matrixphase aus dem Mischoxid (Mo₁₋ₓMₓ)₅O₁₄ bezogen auf ein Schliffbild des Targetmaterials - gemessen mit einem Raman-Mikroskop (mittels Raman-Spektroskopie) - einen Anteil von ≥ 60 Vol.% auf, d.h. er liegt in dem Bereich von 60-100 Vol.%. Insbesondere beträgt der Anteil ≥ 75 Vol.%, d.h. er liegt in dem Bereich von 75-100 Vol.%, noch bevorzugter beträgt der Anteil ≥ 90 Vol.%, d.h. er liegt in dem Bereich von 90-100 Vol.%. Je höher der Anteil der Mischoxidphase ist, desto stärker wird das Targetmaterial durch die oberhalb erläuterten, vorteilhaften Eigenschaften dieser Matrixphase geprägt. Ein sehr hoher Anteil wird nur dann erzielt, wenn die Zusammensetzung des Targetmaterials dem Verhältnis der betreffenden Elemente in dem Mischoxid (Mo₁₋ₓMₓ)₅O₁₄ angenähert ist. Gemäß einer Ausführungsvariante der Erfindung beträgt der Anteil 100 Vol.% (d.h. es sind keine Zweitphasen nachweisbar). Zur Erreichung von 100 Vol.% muss die Zusammensetzung des Targetmaterials weitgehend dem Verhältnis der Elemente in dem Mischoxid entsprechen. Bzgl. der Bestimmung des Anteils in Vol.% wird auf die voranstehende allgemeine Beschreibung sowie auf die nachstehende detaillierte Beschreibung bzgl. der Probenpräparation und der Raman-Spektroskopie Bezug genommen.

Erfindungsgemäss besteht das Targetmaterial zudem aus
a. MoO₂ und Mo₄O₁₁ sowie
b. optional einer oder mehrerer Verbindung(en) aus der Gruppe:
   - MoO₃,
   - weiterer substöchiometrischer Molybdänoxide aus der Gruppe Mo₁₇O₄₇, Mo₅O₁₄, Mo₆O₂₃, Mo₉O₂₆ und Mo₁₈O₅₂,
   - stöchiometrischer (z.B. Ta₂O₅) und/oder substöchiometrischer (z.B. Ta₂O₅₋ₗ; 0<l<1) Ta-Oxid(e),
   - stöchiometrischer (z.B. Nb₂O₅) und/oder substöchiometrischer (z.B. Nb₂O₅₋ₘ; 0<m<1) Nb-Oxid(e),
   - stöchiometrischer (z.B. V₂O₅) und/oder substöchiometrischer (z.B. V₂O₅₋ₙ; 0<n<1) V-Oxid(e), und
   - stöchiometrischer (z.B. TiO₂) und/oder substöchiometrischer (z.B. TiO₂₋ₒ; 0<o<1) Ti-Oxid(e),
als eine oder mehrere Zweitphasen, die als Inseln in der Matrixphase verteilt sind, wobei diese Zweitphasen bezogen auf ein Schliffbild des Targetmaterials - gemessen mit einem Raman-Mikroskop (mittels Raman-Spektroskopie) - in Summe einen Anteil ≤ 40 Vol.% bilden, d.h. der Anteil liegt in dem Bereich von 0,1 - 40 Vol.%. Zweitphasen treten insbesondere dann verstärkt auf, wenn die Zusammensetzung des Targetmaterials von dem Verhältnis der Elemente in dem Mischoxid (Mo₁₋ₓMₓ)₅O₁₄ abweicht. Ist beispielsweise der Anteil an dem Dotierungselement M relativ niedrig, so dass die Bildung des Mischoxids (Mo₁₋ₓMₓ)₅O₁₄ limitiert wird, so treten Molybdänoxidphasen auf. Dabei sind unter den genannten Zweitphasen die oben genannten Phasen MoO₂ und Mo₄O₁₁ bevorzugt, da sie sie eine hohe (nahezu metallische) elektrische Leitfähigkeit (MoO₂: 1,25 × 10⁶ S/m; monoklines Mo₄O₁₁: 1,25 × 10⁶ S/m) und einen niedrigeren Dampfdruck aufweisen, was für die Stabilität des Beschichtungsprozesses vorteilhaft ist. Weitgehend entsprechende Vorteile gelten grundsätzlich auch für die optional vorhandenen Phasen aus Mo₁₇O₄₇, Mo₅O₁₄, Mo₈O₂₃, Mo₉O₂₆ und Mo₁₈O₅₂, die im Rahmen der hier betrachteten Herstellung typischerweise jedoch nicht oder nur zu geringen Anteilen auftreten. Vorzugsweise ist der Anteil der unter a. und b. genannten Zweitphasen ≤ 25 Vol.% (d.h. er liegt im Bereich 0,1 - 25 Vol.%), noch bevorzugter ≤ 10 Vol.% (d.h. er liegt im Bereich 0,1 - 10 Vol.%), so dass der verbleibende Volumenanteil jeweils durch das besonders vorteilhafte Mischoxid (Mo₁₋ₓMₓ)₅O₁₄ gebildet wird.

In dem Targetmaterial liegt, bezogen auf ein Schliffbild desselben - gemessen mit einem Raman-Mikroskop (mittels Raman-Spektroskopie) - der Anteil der Zweitphase MoOs im Bereich von 0 - 2 Vol.%, d.h. der Anteil ist ≤ 2 Vol.%. Der Anteil der Zweitphase MoOs sollte möglichst niedrig gehalten werden, da MoOs elektrisch isolierend ist (elektrische Leitfähigkeit kleiner als 1 × 10⁻⁵ S/m), was zu Partikelbildung beim Beschichtungsprozess führen kann. Zudem ist MoOs wasserlöslich, was nachteilig bei der mechanischen Bearbeitung sowie der Lagerung des Targets ist. Vorzugsweise ist eine Zweitphase MoOs in dem Targetmaterial mittels Raman- Spektroskopie überhaupt nicht nachweisbar (d.h. gemessener Anteil von 0 Vol.%), bzw. wird - wenn sie nicht ganz vermeidbar ist - auf einen Anteil im Bereich von 0,1 - 1,0 Vol.% gehalten.

In dem erfindungsgemäßen Targetmaterial liegt der Sauerstoff-Gehalt in Gew.% im Bereich von 26 bis 32 Gew.%. Der Sauerstoff-Gehalt in der abgeschiedenen Schicht beeinflusst die optische Reflexion, so dass vorzugsweise in dem Targetmaterial ein weitgehend entsprechender Sauerstoff-Gehalt, der typischerweise in dem oben genannten Bereich liegt, eingestellt wird. Weiterhin wird innerhalb dieses Bereiches eine ausreichende elektrische Leitfähigkeit erzielt, so dass ein DC (direct current; Gleichstrom) Sputterprozess ermöglicht wird (während elektrisch isolierende Targets mit einem RF (RF: radio frequency; d.h. Hochfrequenz) Sputterprozess (d.h. Wechselstrom) gesputtert werden müssen, was mit erhöhten Kosten (insbesondere bzgl. der Ausgestaltung der Sputteranlage) verbunden ist. Der Sauerstoff-Gehalt kann dabei - wie nachstehend noch ausführlicher beschrieben wird - im Rahmen der Herstellung durch Einwaage entsprechender oxidhaltiger Pulver eingestellt werden, so dass der eingewogene Sauerstoff-Anteil (im Verhältnis zu dem eingewogenen MetallAnteil) dem gewünschten Sauerstoff-Gehalt des Targetmaterials entspricht. Gleichzeitig ist der genannte Sauerstoff-Gehalt günstig für das Sinterverhalten und die Ausbildung des Mischoxids (Mo₁₋ₓMₓ)₅O₁₄ im Rahmen der Herstellung. Die Betrachtung lediglich des Gesamt-Sauerstoff-Gehalts in dem Targetmaterial ist zielführend, da sich die exakte Besetzung der verschiedenen Gitterplätze in den Metalloxidphasen ggf. auch temperaturabhängig ändern kann. Der Gesamt-Sauerstoff-Gehalt im Targetmaterial wird vorliegend mittels Trägergasheißextraktion (Nachweis des Sauerstoffes als CO bzw. CO₂ mittels Infrarotmesszelle, z.B. mit einem Gerät LECO RO300 oder LECO 836) ermittelt.

Gemäß der Erfindung liegt in dem Targetmaterial der Anteil des (mindestens einen) Dotierungselements M in at.% relativ zu dem Gesamtgehalt an Mo und dem Dotierungselement M in at.% in Summe, d.h. M/(Mo+M), in dem Bereich von 0,02 - 0,15. Ein Mindestgehalt des (mindestens einen) Dotierungselements M ist erforderlich, damit sich in dem Targetmaterial das Mischoxid (Mo₁₋ₓMₓ)₅O₁₄ als Matrixphase ausbilden kann. Ein gewisser Spielraum besteht dabei, da der Anteil x des Dotierungselements M innerhalb der Matrixphase (Mo₁₋ₓMₓ)₅O₁₄ bis zu einem gewissen Grad variieren und damit auch leicht reduziert sein kann. Weiterhin ist ein Mindestgehalt des Dotierungselements M erforderlich, damit die gewünschten Eigenschaften der hergestellten Schicht (insbesondere bzgl. Nassätzverhalten) vorliegen. Umgekehrt ist ein zu hoher Gehalt des Dotierungselements M nachteilig, da das Dotierungselement M dann nicht mehr in der Matrixphase aufgenommen werden kann und folglich zu einem erhöhten Anteil des Oxids des Dotierungselements (z.B. Ta₂O₅, Nb₂O₅, V₂O₅, TiO₂) führt, in Form einer Zweitphase. Weiterhin nimmt zum Teil die Reflexion der hergestellten Schichten bei zunehmendem Gehalt des Dotierungselements M (z.B. bei Ta) wieder zu und auch die Ätzrate entspricht nicht mehr dem gewünschten Bereich. Vor diesem Hintergrund ist der Bereich von 0,05 - 0,12 für das Verhältnis M/(Mo+M) besonders bevorzugt. Das gewünschte Verhältnis M/(Mo+M) kann im Rahmen der Herstellung durch Einwaage entsprechender Pulver eingestellt werden, da dieses bei der nachstehend beschriebenen Herstellungsroute weitgehend unverändert bleibt. Am Targetmaterial selbst können die Anteile der enthaltenen Metalle sowie das Verhältnis M/(Mo+M) mittels chemischer Analyse, insbesondere mittels ICP-MS (Inductively Coupled Plasma Mass Spectroscopy; Massenspektrometrie mit induktiv gekoppeltem Plasma) oder mit ICP-OES (Inductively Coupled Plasma Optical Emission Spectrometry; Optische Emissionsspektrometrie mit induktiv gekoppeltem Plasma), bestimmt werden.

Gemäß einer Weiterbildung wird in dem Targetmaterial das Dotierungselement M durch Ta gebildet und die Matrixphase aus dem Mischoxid wird durch (Mo₁₋ₓTaₓ)₆O₁₄ mit 0,06 ≤ x ≤ 0,08 gebildet. Typischerweise nimmt der Ta-Anteil x in der Matrixphase (Mo₁₋ₓTaₓ)₆O₁₄ den Wert 0,07 ein. Je nach Verfügbarkeit von Ta zur Bildung der Matrixphase während der Herstellung (d.h. insbesondere je nach Zusammensetzung und Mengenverhältnis der Ausgangspulver) liegt x in der Regel innerhalb des Bereichs 0,06 ≤ x ≤ 0,08, wobei die Matrixphase in diesem Bereich stabil ausgebildet wird. Wie oberhalb erwähnt, ist Ta hinsichtlich der Beeinflussung der Nassätzrate und der Verfügbarkeit besonders bevorzugt. Auch die Matrixphase (Mo₁₋ₓTaₓ)₆O₁₄ hat sich in der Praxis als besonders vorteilhaft herausgestellt.

Vorzugsweise wird ein möglichst hoher Anteil des zugegebenen Dotierungselements M (hier: Ta) in die Matrixphase aus dem Mischoxid (Mo₁₋ₓMₓ)₅O₁₄ eingebaut und vorzugsweise liegt das Dotierungselement M (hier: Ta) - sofern es nicht vollständig eingebaut wird - als Metalloxid (z.B. Mischoxid, Ta₂O₅) und nicht als metallisches Element vor. Ta als metallische Phase würde zu deutlich abweichenden Eigenschaften führen. Auch der Anteil von Ta₂O₅ ist bevorzugt relativ niedrig, da Ta₂O₅ dielektrisch ist und damit die Ursache für Partikel und Schichtfehler beim Sputtern sein kann. Ferner wäre Ta₂O₅ als dünne Teilschicht in der hergestellten Schicht optisch transparent und würde damit die optischen Eigenschaften der Schicht verschlechtern. Dementsprechend liegt Ta (vorzugsweise als einziges enthaltenes Dotierungselement M) in dem Targetmaterial gemäß einer Weiterbildung vollständig als Metalloxid (z.B. Mischoxid, Ta₂O₅) vor (d.h. nicht als metallisches Element), wobei in dem Targetmaterial bezogen auf ein Schliffbild desselben - gemessen mit einem Raman-Mikroskop (mittels Raman-Spektroskopie) - der Anteil der Phase Ta₂O₅ ≤ 3 Vol.% (d.h. Anteil von 0-3 Vol.%), vorzugsweise ≤ 1 Vol.% (d.h. Anteil von 0-1 Vol.%), ist. Dies gilt insbesondere für einen Anteil des Dotierungselements Ta in at.% relativ zu dem Gesamtgehalt an Mo und Ta in at.%, d.h. M/(Mo+M), in dem Bereich von 0,02 - 0,15, vorzugsweise im Bereich von 0,05 - 0,12.

Gemäß einer Weiterbildung wird in dem Targetmaterial das Dotierungselement M durch Nb gebildet und die Matrixphase aus dem Mischoxid wird durch (Mo₁₋ₓNbₓ)₅O₁₄ mit 0,07 ≤ x ≤ 0,12 gebildet. Je nach Verfügbarkeit von Nb zur Bildung der Matrixphase während der Herstellung (d.h. insbesondere je nach Zusammensetzung und Mengenverhältnis der Ausgangspulver) liegt x in der Regel innerhalb des Bereichs von 0,07 ≤ x ≤ 0,12, wobei die Matrixphase in diesem Bereich stabil ausgebildet wird. Wie oberhalb erwähnt, ist Nb hinsichtlich der Beeinflussung der Nassätzrate und der preisgünstigen Verfügbarkeit vorteilhaft, auch weil sich die Matrixphase über einen breiteren Bereich von 0,07 ≤ x ≤ 0,12 stabil ausbildet.

Entsprechend wie oberhalb bzgl. Ta erläutert, wird vorzugsweise ein möglichst hoher Anteil des zugegebenen Dotierungselements M (hier: Nb) in die Matrixphase aus dem Mischoxid (Mo₁₋ₓMₓ)₅O₁₄ eingebaut und vorzugsweise liegt das Dotierungselement M (hier: Nb) - sofern es nicht vollständig eingebaut wird - als Metalloxid (z.B. Mischoxid, Nb₂O₅) und nicht als metallisches Element vor. Dementsprechend liegt Nb (vorzugsweise als einziges enthaltenes Dotierungselement M) in dem Targetmaterial gemäß einer Weiterbildung vollständig als Metalloxid (z.B. Mischoxid, Nb₂O₅) vor (d.h. nicht als metallisches Element), wobei in dem Targetmaterial bezogen auf ein Schliffbild desselben - gemessen mit einem Raman-Mikroskop (mittels Raman-Spektroskopie) - der Anteil der Phase Nb₂O₅ ≤ 3 Vol.% (d.h. Anteil von 0-3 Vol.%), vorzugsweise ≤ 1 Vol.% (d.h. Anteil von 0-1 Vol.%), ist. Dies gilt insbesondere für einen Anteil des Dotierungselements Nb in at.% relativ zu dem Gesamtgehalt an Mo und Nb in at.%, d.h. M/(Mo+M), in dem Bereich von 0,02 - 0,15, vorzugsweise im Bereich von 0,05-0,12.

Gemäß einer Weiterbildung weist das Targetmaterial eine relative Dichte von ≥ 95% (d.h. in einem Bereich von 95 - 99,9%), insbesondere von ≥ 97% (d.h. in einem Bereich von 97 - 99,9%), vorzugsweise von ≥ 98% (d.h. in einem Bereich von 98 - 99,9%) auf. Ein kompaktes Targetmaterial mit einer hohen relativen Dichte ist für die Qualität der abgeschiedenen Schichten wichtig, da weniger dichte Targetmaterialien beim Sputtern zu Blitzentladungen ("Ares") und Partikelbildung führen können. Die Bestimmung der relativen Dichte erfolgt mittels digitaler Bildanalyse anhand von lichtmikroskopischen Bildaufnahmen des metallographischen Schliffs des Targetmaterials, bei dem der relative Flächenanteil "FA" der Poren (FA: Flächenanteil der Poren relativ zur untersuchten Gesamtfläche) ausgewertet wird. Die relative Dichte entspricht dann dem Wert (1-FA), wobei sie als arithmetisches Mittel aus drei derartigen Porositätsmessungen berechnet wird. Die Vorgehensweise ist nachstehend im Detail beschrieben.

Gemäß einer Weiterbildung weit das Targetmaterial eine elektrische Leitfähigkeit von ≥ 100 S/m bei 25°C auf. Hierdurch wird ein DC Sputtern ermöglicht und auch in der hergestellten Schicht wird eine ausreichende elektrische Leitfähigkeit erzielt. Die elektrische Leitfähigkeit wird dabei mit der 4-Punkt-Messmethode über einen Widerstands-Messstand (z.B. Ulvac ZEM3) gemessen.

Gemäß einer Weiterbildung liegt das Targetmaterial als ein pulvermetallurgisch hergestellter (makroskopischer) Festkörper vor. Die pulvermetallurgische Herstellungsroute , die nicht erfindungsgemäss ist, ermöglicht eine kostengünstige Herstellung des Targetmaterials in industriellem Maßstab als kompaktes Bauteil (kompaktes Targetmaterial von z.B. mindestens 1 kg pro Targetsegment) mit hoher relativer Dichte und hoher Phasenreinheit innerhalb kurzer Prozesszeiten (z.B. Haltezeiten typischerweise < 12 Stunden). Unter einer pulvermetallurgischen Herstellung wird dabei verstanden, dass entsprechende Ausgangspulver (die im Falle mehrerer Pulver vorher entsprechend gemischt werden) durch Anwendung von Druck und/oder Temperatur verdichtet werden. Die pulvermetallurgische Herstellung führt dabei zu einer charakteristischen Mikrostruktur des Targetmaterials, insbesondere zu einem mehrphasigen und feinkörnigen Gefüge. Die pulvermetallurgische Herstellung ist für einen Fachmann ohne weiteres an dem Targetmaterial anhand eines Schliffbildes im Lichtmikroskop, im Rasterelektronenmikroskop (REM) oder über Raman-Mikroskop erkennbar.

Als Ausgangspulver wird vorzugsweise eine Pulvermischung aus MoO₂, MoO₃, gegebenenfalls enthaltend geringe Anteile an substöchiometrischen Molybdänoxiden wie insbesondere Mo₄O₁₁, sowie aus einem oder mehreren Oxiden des Dotierungselements M (Ta₂O₅, V₂O₅, Nb₂O₅, TiO₂) gebildet. Die Anteile der verschiedenen Pulver werden so eingewogen, dass das gewünschte Mengenverhältnis der Elemente Mo, M und O eingestellt wird. MoO₂ und MoOs sind leicht zugängliche, günstige und unter Umgebungsbedingungen thermodynamisch stabile, einfach zu handhabende Rohstoffe. Substöchiometrische Oxide können durch Reduktion von MoOs-Pulver in einer entsprechenden Atmosphäre wie H₂ hergestellt werden.

Um die Ausbildung der gewünschten Matrixphase aus dem Mischoxid (Mo₁₋ₓMₓ)₅O₁₄ während des nachfolgenden Verdichtungsschritts mit dem gewünschten hohen Anteil zu erzielen, ist zum einen auf ein entsprechendes, nahe an dem Mischoxid liegendes Mengenverhältnis der eingewogenen Pulver zu achten. Ferner ist wesentlich, dass die eingesetzten Pulver sehr feinkörnig sind (mit d50-Werten typischerweise < 10 µm) und vor dem Schritt des Verdichtens sehr gut durchmischt werden. Wie auch anhand der Herstellungsbeispiele erläutert wird, werden bei dem MoO₂-Pulver und dem Pulver aus dem Oxid des Dotierungselements M (sowie ggf. auch bei den substöchiometrischen Molybdänoxiden) jeweils der Grobanteil > 63 µm durch einen entsprechenden Siebschritt (z.B. Sieb mit einer Maschenweite von 63 µm) abgesiebt. Auch bei dem MoOs-Pulver wird ein besonders feines Pulver (z.B. mit einem d50-Wert von 3 µm, Partikelgrößenmessung mittels Laserbeugung, z.B. mittels Malvern-Gerät) eingesetzt. Die Mischung der Pulver wird vorzugsweise in einem Intensivmischer oder auch mit einem Pflugscharmischer durchgeführt, wobei auf eine sehr gute Durchmischung der Pulver zu achten ist.

Das Verdichten kann insbesondere mittels Heißpressen, Heiß-isostatisch-Pressen, Spark Plasma Sintern (SPS) oder Pressen-Sintern erfolgen. Die Verdichtung erfolgt dabei insbesondere bei Temperaturen zwischen 600 und 800 °C und Pressdrücken zwischen 15 und 110 MPa. Vorzugsweise erfolgt die Verdichtung, insbesondere wenn erhöhte Temperaturen eingestellt werden, in Vakuum oder in Schutzgasatmosphäre (z.B. Argon). Bei SPS erfolgt die Verdichtung über Anwendung von Druck und Temperatur, wobei die Wärme intern durch einen durch die Pulvermischung geführten elektrischen Strom erzeugt wird. Beim Heißpressen erfolgt die Verdichtung ebenfalls über Anwendung von Druck und Temperatur, wobei die Wärme von außerhalb über eine beheizte Form zugeführt wird. Beim Heiß-isostatisch Pressen befindet sich das Ausgangspulver in einer abgeschlossenen Kapsel und die Verdichtung erfolgt unter Anwendung von Druck und Temperatur auf die Kapsel. Bei einer Verdichtung mittels Pressen-Sintern wird das Ausgangspulver zu einem Grünling gepresst und dieser anschließend durch Wärmebehandlung unterhalb der Schmelztemperatur gesintert.

Während des Verdichtungsprozesses werden die Ausgangspulver in einer Festphasenreaktion, bzw. je nach chemischer Zusammensetzung und Prozessbedingungen auch Flüssigphasenreaktionen, bzw. Mehrphasenreaktionen (z.B. fest-flüssig) in das Targetmaterial umgewandelt. Die dabei ablaufenden Reaktionen ähneln einer Komproportionierung: MoOs wird zu ggf. verschiedenen substöchiometrischen Oxiden (z.B. Mo₁₈O₅₂, MoO₄O₁₁, ...) reduziert, während MoO₂ zumindest anteilig zu ggf. verschiedenen substöchiometrischen Oxiden oxidiert wird. Ferner geht das mindestens eine Oxid des Dotierungselements M (Ta₂O₅, V₂O₅, Nb₂O₅, TiO₂) zu einem hohen Anteil in das Mischoxid (Mo₁₋ₓMₓ)₅O₁₄ zur Bildung der Matrixphase ein. Nach dem Verdichten kann eine mechanische Nachbearbeitung, beispielsweise durch spanabhebende Werkzeuge, zur gewünschten Endgeometrie bzw. zur Oberflächenaufbereitung (Einstellung einer gewünschten Rauigkeit der Oberfläche) erfolgen. Gegebenenfalls sind noch weitere Bauteile, wie z.B. Rückplatte(n), Trägerrohr(e), Anschlussstück(e), Einsätz(e) zur Vervollständigung des Sputteringtargets anzubringen.

Gemäß einer Weiterbildung der vorliegenden Erfindung sind in dem Targetmaterial bezogen auf ein Schliffbild desselben - gemessen mit einem Raman-Mikroskop (mittels Raman-Spektroskopie) - in der Matrixphase eine oder mehrere Zweitphasen als fein und gleichmäßig verteilte, kleine Inseln ausgebildet. Insbesondere weisen mindestens 95% der Inseln der Zweitphase(n) einen äquivalenten Kreisdurchmesser (jeweils errechnet aus der betreffenden Fläche der Insel, dargestellt in Form eines Kreises mit gleicher Fläche und mit "äquivalentem Kreisdurchmesser") von jeweils ≤ 60 µm auf. Betrachtet wird dabei die Anzahl der "kleinen Inseln mit einem äquivalenten Kreisdurchmesser von jeweils ≤ 60 µm" relativ zu der Gesamtanzahl der Inseln einer repräsentativ gewählten, analysierten Fläche von 1.000 µm × 1.000 µm. Diese feine Insel-Struktur der Zweitphase(n) ist mit einer Raman-Aufnahme vom Schliffbild visualisierbar und kann mittels quantitativer Bildauswertung bzgl. der Fläche und Größe der Inseln entsprechend ausgewertet werden.

Die vorliegende Erfindung betrifft ferner die Verwendung eines Sputteringtargets gemäß der vorliegenden Erfindung, das zusätzlich gemäß einer oder mehrerer der oberhalb beschriebenen Weiterbildungen und Varianten ausgebildet sein kann, zur Gasphasen-Abscheidung einer molybdänoxidhaltigen Schicht, wobei das Sputterverfahren als DC-Sputterverfahren bzw. gepulstes DC-Sputterverfahren in einer Edelgasatmosphäre ohne Sauerstoff oder alternativ unter Zufuhr von höchstens 20 Vol.% Sauerstoff als Reaktivgas erfolgt. Beim Gleichspannungssputtern, oder DC-Sputtern, wird zwischen dem als Kathode geschalteten Sputteringtarget und einer Anode (in der Regel das Gehäuse der Beschichtungsanlage und/oder Abschirmbleche in der Vakuumkammer) eine Gleichspannung angelegt. Das DC-Sputterverfahren bzw. gepulste DC-Sputterverfahren erfolgt dabei in einer Edelgasatmosphäre, insbesondere einer Argongasatmosphäre, bevorzugt nicht-reaktiv ohne zusätzliche Zufuhr von Sauerstoff. Die dabei abgeschiedenen Schichten haben gegebenenfalls aufgrund einer leichten Sauerstoff-Verarmung beim Beschichtungsprozess (Abtransport von gebildetem Sauerstoff über das abgesaugte Prozessgas) einen geringfügig niedrigeren Sauerstoff-Gehalt als das verwendete Targetmaterial, wobei dies je nach Beschichtungsanlage und Betriebsweise leicht variieren kann. Um molybdänoxidhaltige Schichten mit einem höheren Sauerstoffgehalt als dem des Targetmaterials herzustellen, kann das Targetmaterial auch reaktiv unter Zufuhr von höchstens 20 Vol.% Sauerstoff (bezogen auf die Zusammensetzung des Reaktivgases) gesputtert werden, vorzugsweise < 10 Vol.%, noch bevorzugter < 5 Vol.%, wobei durch den Einsatz eines oxidischen Targetmaterials die Menge an zugeführtem Sauerstoff vergleichsweise niedrig gehalten werden kann. Die Nachteile vom reaktiven Sputtern (Hystereseeffekte, potenzielle Inhomogenitäten der abgeschiedenen Schicht) wirken sich daher nicht so stark aus.

Weitere Vorteile und Zweckmäßigkeiten der Erfindung ergeben sich anhand der nachfolgenden Beschreibung von Ausführungsbeispielen unter Bezugnahme auf die beigefügten Figuren. In den Figuren, die Raman-Spektren zeigen, ist jeweils die Intensität in (Anzahl bzw. Counts) über der Raman-Verschiebung in (cm⁻¹) (Raman shift) aufgetragen.

Von den Figuren zeigen:
- Fig. 1:: Raman-Referenzspektrum des Mischoxids (Mo_{0.93}Ta_{0.007})₅O₁₄;
- Fig. 2:: Raman-Referenzspektrum von Ta₂O₅;
- Fig. 3:: Raman-Referenzspektrum von Mo₁₈O₅₂;
- Fig. 4:: Raman-Referenzspektrum von MoO₂;
- Fig. 5:: Raman-Referenzspektrum von MoOs;
- Fig. 6:: Raman-Referenzspektrum von Mo₄O₁₁;
- Fig. 7:: eine mittels Raman-Mapping erstellte Mikrostruktur eines erfindungsgemäßen Ausführungsbeispiels;
- Fig. 8:: eine mittels Raman-Mapping erstellte Mikrostruktur eines Vergleichsbeispiels;
- Fig. 9:: ein Diagramm, in dem die Abscheideraten jeweils in (nm/min), d.h. in Nanometer/Minute, für zwei erfindungsgemäße Sputteringtargets (Bsp. 1, Bsp. 2) und ein Vergleichsbeispiel (Referenz) aufgetragen sind (jeweils kurz als MoO_{z} (2 < z < 3) mit dem entsprechenden molaren Anteil an Ta₂O₅, jeweils bezogen auf die Ausgangspulver, bezeichnet); und
- Fig. 10:: ein Diagramm, in dem die Reflektivität in (%) über der Wellenlänge (nm) (Nanometer) aufgetragen ist, für Schichtsysteme, die mit den in Fig. 8 dargestellten zwei erfindungsgemäßen Sputteringtargets (Bsp. 1, Bsp. 2) und dem Vergleichsbeispiel (Referenz) abgeschieden wurden.

### Beispiel 1:

MoO₂-Pulver (Plansee SE; d50-Wert von ca. 6 µm) wird in einem Sieb mit Maschenweite 63 µm abgesiebt, wobei der Grobanteil >63 µm nicht weiterverwendet wird. 40 Mol.% des so erhaltenen MoO₂-Pulvers werden mit 57 Mol.% MoOs-Pulver (Molymet, vorliegend mit einem d50-Wert von ca. 3 µm) und 3 Mol.% Tantalpentoxidpulver (H.C. Starck, d50-Wert von ca. 2 µm; abgesiebt auf <63 µm; Ta₂O₅) in einem Pflugscharmischer (Lödige) für 20 min. gemischt, so dass sich eine homogene Verteilung zwischen den Pulverkomponenten ergibt.

Die erhaltende Pulvermischung wird in eine Graphitform mit den Abmessungen 0250 mm (d.h. Durchmesser von 250 mm) und einer Höhe von 50 mm gegeben und in einer Heißpresse unter Vakuum bei einem Pressdruck von 30 MPa, einer Temperatur von 800 °C und einer Haltezeit von 480 Minuten verdichtet. Das kompaktierte Bauteil weist eine relative Dichte von 97,5% auf. Der überwiegende Anteil des erhaltenen Targetmaterials besteht aus der Matrixphase aus dem Mischoxid (Mo_{0.93}Ta_{0.07})₅O₁₄ mit einem Anteil von 79,4 Vol.%. Das Targetmaterial weist zusätzlich eine MoO₂-Phase mit einem Anteil von 8,5 Vol.% und eine Mo₄O₁₁-Phase mit einem Anteil von 12,1 Vol.% auf.

### Beispiel 2:

MoO₂-Pulver (Plansee SE; d50-Wert von ca. 6 µm) wird in einem Sieb mit Maschenweite 63 µm abgesiebt, wobei der Grobanteil >63 µm nicht weiterverwendet wird. 40 Mol.% des so erhaltenen MoO₂-Pulvers werden mit 57 Mol.% MoOs-Pulver (Molymet, vorliegend mit einem d50-Wert von ca. 3 µm) und 3 Mol.% Tantalpentoxidpulver (H.C. Starck, d50-Wert von ca. 2 µm; abgesiebt auf <63 µm; Ta₂O₅) in einem Intensivmischer (Eirich) für 10 min. gemischt, so dass sich eine homogene Verteilung zwischen den Pulverkomponenten ergibt. Die erhaltende Pulvermischung wird in eine Graphitform mit den Abmessungen 0250 mm (d.h. Durchmesser von 250 mm) und einer Höhe von 50 mm gegeben und in einer Heißpresse unter Vakuum bei einem Pressdruck von 30 MPa, einer Temperatur von 800 °C und einer Haltezeit von 360 Minuten verdichtet. Das kompaktierte Bauteil weist eine relative Dichte von 99,5% auf. Der überwiegende Anteil des erhaltenen Targetmaterials besteht aus der Matrixphase aus dem Mischoxid (Mo_{0.93}Ta_{0.07})₅O₁₄ mit einem Anteil von 94,3 Vol.%.Das Targetmaterial weist zusätzlich eine MoO₂-Phase mit einem Anteil von 2,6 Vol.%, eine Mo₄O₁₁-Phase mit einem Anteil von 3,0 Vol.% und eine Ta₂O₅-Phase mit einem Anteil von 0,1 Vol.% auf.

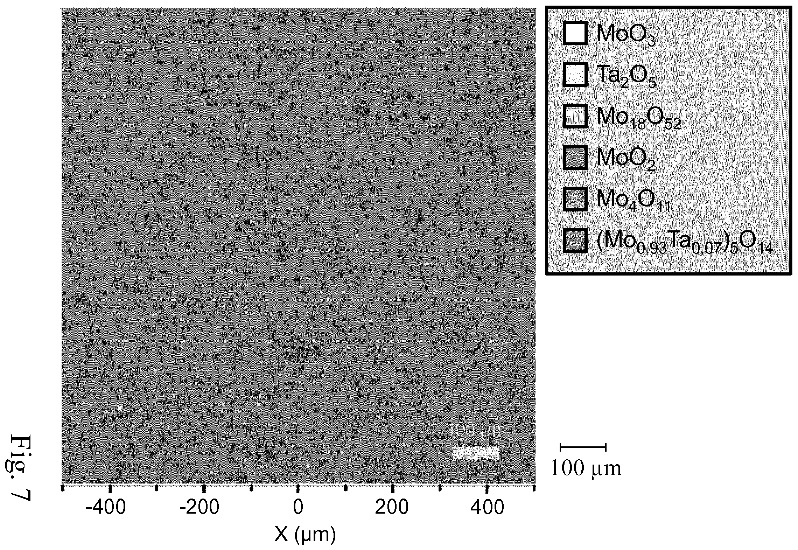

In Fig. 7 ist die mittels Raman-Mapping ermittelte Mikrostruktur des so hergestellten Targetmaterials dargestellt. In der Mikrostruktur sind Bereiche mit Mo0₂-Phase, Bereiche mit Mo₄O₁₁-Phase und Bereiche mit Ta₂O₅-Phase entsprechend der oben dargestellten Phasenanteile erkennbar. Diese verschiedenen Phasen sind in eine Matrix, welche durch die (Moo.₉₃Tao.o₇)₅0i₄-Phase gebildet wird, eingebettet.

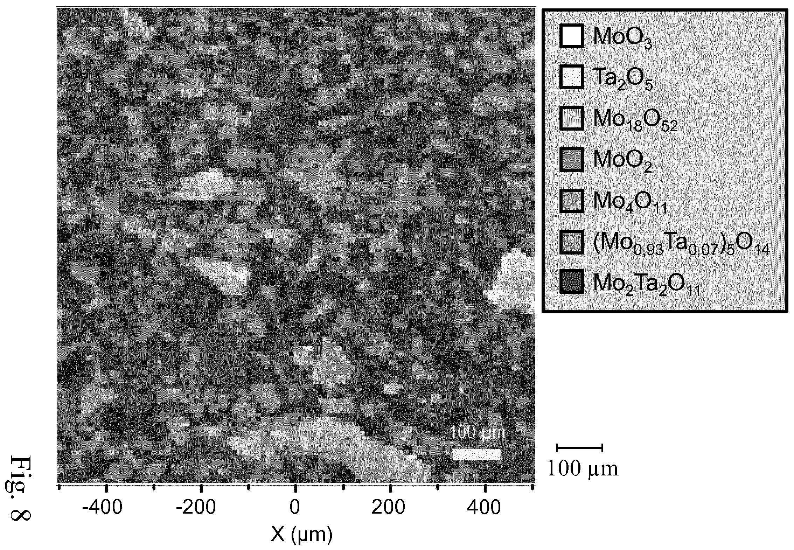

Demgegenüber ist in Fig. 8 als Vergleichsbeispiel ein Raman-Mapping eines Targetmaterials gezeigt, das keine Matrixphase aus dem Mischoxid (Mo_{0.93}Ta_{0.07})₅O₁₄ aufweist. Die (Mo_{0.93}Ta_{0.07})₅O₁₄-Phase ist zu einem Anteil von 24,0 Vol.% vorhanden. Die Mo₄O₁₁-Phase nimmt einen Anteil von 50,3 Vol.%, die MoO₂-Phase einen Anteil von 12,5 Vol.%, die Mo₁₈O₅₂-Phase einen Anteil von 5,0 Vol.%, die Ta₂O₃-Phase einen Anteil von 2,4 Vol.% und die MoOs-Phase einen Anteil von 5,8 Vol.% ein. Wie ferner aus Fig. 8 ersichtlich ist, sind die Phasen innerhalb des Targetmaterials des Vergleichsbeispiels deutlich grobkörniger und ungleichmäßiger verteilt im Vergleich zu dem erfindungsgemäßen Targetmaterial aus Fig. 7.

### Beispiel 3:

MoO₂-Pulver (Plansee SE; d50-Wert von ca. 6 µm) wird in einem Sieb mit Maschenweite 63 µm abgesiebt, wobei der Grobanteil >63 µm nicht weiterverwendet wird. 52 Mol.% des so erhaltenen MoO₂-Pulvers werden mit 42 Mol.% MoOs-Pulver (Molymet, vorliegend mit einem d50-Wert von ca. 3 µm) und 6 Mol.% Tantalpentoxidpulver (H.C. Starck, d50-Wert von ca. 2 µm; abgesiebt auf <63 µm; Ta₂O₅) in einem Pflugscharmischer (Lödige) für 20 min. gemischt, so dass sich eine homogene Verteilung zwischen den Pulverkomponenten ergibt. Die erhaltende Pulvermischung wird in eine Graphitform mit den Abmessungen 0250 mm (d.h. Durchmesser von 250 mm) und einer Höhe von 50 mm gegeben und in einer Heißpresse unter Vakuum bei einem Pressdruck von 30 MPa, einer Temperatur von 800 °C und einer Haltezeit von 480 Minuten verdichtet. Das kompaktierte Bauteil weist eine relative Dichte von 97,5% auf. Der überwiegende Anteil des erhaltenen Targetmaterials besteht aus der Matrixphase aus dem Mischoxid (Mo_{0.93}Ta_{0.07})₅O₁₄ mit einem Anteil von 80,3 Vol.%. Das erhaltene Targetmaterial weist eine MoO₂-Phase mit einem Anteil von 18,9 Vol.%, eine Mo₄O₁₁-Phase mit einem Anteil von 0,2 Vol.% und eine Ta₂O₅-Phase mit einem Anteil von 0,6 Vol.% auf.

### Beispiel 4:

MoO₂-Pulver (Plansee SE; d50-Wert von ca. 6 µm) wird in einem Sieb mit Maschenweite 63 µm abgesiebt, wobei der Grobanteil >63 µm nicht weiterverwendet wird. 45 Mol.% des so erhaltenen MoO₂-Pulvers werden mit 51 Mol.% MoOs-Pulver (Molymet, vorliegend mit einem d50-Wert von ca. 3 µm) und 4 Mol.% Niobpentoxidpulver (H.C. Starck, d50-Wert von ca. 2 µm; abgesiebt auf <63 µm; Nb₂O₅) in einem Pflugscharmischer (Lödige) für 20 min. gemischt, so dass sich eine homogene Verteilung zwischen den Pulverkomponenten ergibt. Die erhaltende Pulvermischung wird in eine Graphitform mit den Abmessungen 0250 mm (d.h. Durchmesser von 250 mm) und einer Höhe von 50 mm gegeben und in einer Heißpresse unter Vakuum bei einem Pressdruck von 30 MPa, einer Temperatur von 800 °C und einer Haltezeit von 360 Minuten verdichtet. Der überwiegende Anteil des erhaltenen Targetmaterials besteht aus der Matrixphase aus dem Mischoxid (Mo_{0.91}Nb_{0.09})₅O₁₄-Phase mit einem Anteil von 78,6 Vol.%. Das kompaktierte Bauteil weist eine relative Dichte von 98,2% auf. Das erhaltene Targetmaterial weist eine MoO₂-Phase mit einem Anteil von 18,7 Vol.%, eine Mo₄O₁₁-Phase mit einem Anteil von 2,6 Vol.% und eine Nb₂O₃-Phase mit einem Anteil von 0,1 Vol.% auf.

### Beispiel 5:

MoO₂-Pulver (Plansee SE; d50-Wert von ca. 6 µm) wird in einem Sieb mit Maschenweite 63 µm abgesiebt, wobei der Grobanteil >63 µm nicht weiterverwendet wird. 39 Mol.% des so erhaltenen MoO₂-Pulvers werden mit 52 Mol.% MoOs-Pulver (Molymet, vorliegend mit einem d50-Wert von ca. 3 µm) und 8 Mol.% Titandioxidpulver (Rutil; d50-Wert von < 1 µm; TiO₂) in einer Kugelmühle für 10 min. gemahlen und anschließend in einem Intensivmischer (Eirich) für 10 min. gemischt, so dass sich eine homogene Verteilung zwischen den Pulverkomponenten ergibt. Die erhaltende Pulvermischung wird in eine Graphitform mit den Abmessungen Ø100mm und einer Höhe von 50 mm gegeben und in einer Heißpresse unter Vakuum bei einem Pressdruck von 30 MPa, einer Temperatur von 800 °C und einer Haltezeit von 120 min. verdichtet. Das kompaktierte Bauteil weist eine relative Dichte von 91,2% auf. Das erhaltene Targetmaterial weist eine Matrixphase aus dem Mischoxid (Mo_{0.97}Ti_{0.03})₅O₁₄ auf.

### Sputterversuche:

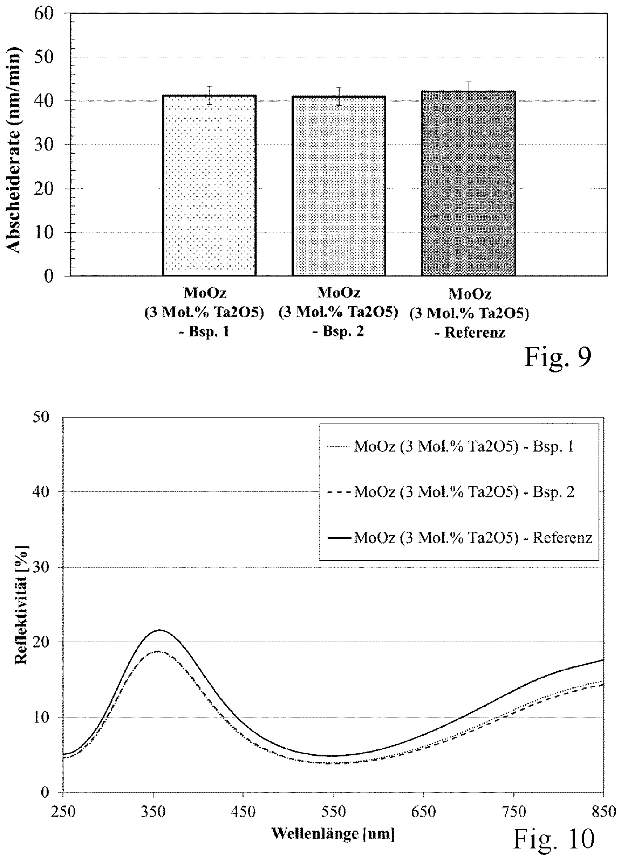

Im Rahmen einer Versuchsserie wurden die nach Beispiel 1 und Beispiel 2 hergestellten Molybdän-Tantal-Oxid-Targetmaterialien im Vergleich mit einem nicht-erfindungsgemäßen Molybdän-Tantal-Oxid-Targetmaterial (Referenz) bei vorgegebenen Prozessbedingungen nicht-reaktiv gesputtert, um die Schichteigenschaften zu ermitteln. Das als Referenz verwendete Molybdän-Tantal-Oxid-Targetmaterial wies die gleiche Zusammensetzung wie in den Beispielen 1 und 2 auf, ohne dass jedoch eine Matrixphase aus dem Mischoxid (Mo_{0.93}Ta_{0.07})₅O₁₄ vorhanden war. Es wurde dabei eine Sputterleistung von 100 W und ein Prozessdruck des Argons von 5,0 × 10⁻³ mbar (22 sccm; sscm: Standardkubikzentimeter pro Minute) verwendet. Die Abscheiderate der verwendeten Sputtertargets ist in Fig. 9 dargestellt, wobei die linke Säule in Fig. 9 dem Targetmaterial aus Beispiel 1 (Bsp. 1), die mittlere Säule dem Targetmaterial aus Beispiel 2 (Bsp. 2) und die rechte Säule dem Targetmaterial der Referenz entspricht.

Die Reflektivität der erzeugten Schichten wurde als Kriterium für die Beurteilung verwendet. Zur Bestimmung der Reflektivität wurden Glassubstrate (Corning Eagle XG, 50 × 50 × 0,7 mm³) mit Molybdän-Tantal-Oxid und einer Deckschicht aus 200 nm Al (Aluminium) beschichtet. Hierbei wurden die oberhalb genannten, nach Beispiel 1 und Beispiel 2 hergestellten Molybdän-Tantal-Oxid-Targetmaterialien im Vergleich zu dem oben genannten nicht-erfindungsgemäßen Molybdän-Tantal-Oxid-Targetmaterial (Referenz) bei vorgegebenen Prozessbedingungen nicht-reaktiv gesputtert. Die Reflektion wurde durch das Glassubstrat hindurch unter Verwendung eines Perkin Elmer Lambda 950 Fotospektrometers über den angegebenen Wellenbereich hinweg gemessen. Um eine möglichst geringe Reflektivität zu erhalten, wurde die Schichtdicke des Molybdän-Tantal-Oxids in einem Bereich von 40 bis 60 nm variiert. Die Ergebnisse aus dieser Versuchsserie für eine Molybdän-Tantal-Oxid Schichtdicke von 50 nm sind in Fig. 10 dargestellt, wobei jeweils die Reflektivität in (%) über der Wellenlänge in (nm; Nanometer) aufgetragen ist. Dabei kommen die Reflektivitätskurven aus Beispiel 1 (Bsp. 1; gepunktete Kurve) und Beispiel 2 (Bsp. 2; gestrichelte Kurve) fast aufeinander zu liegen, außer dass die Reflektivitätskurve von Beispiel 1 im Bereich höherer Wellenlängen geringfügig erhöht ist. Die Kurven liegen deutlich unterhalb der durchgezogen eingezeichneten Reflektivitätskurve der nicht erfindungsgemäßen Referenz.

Wie aus einem Vergleich der Fig. 9 und 10 ersichtlich ist, wird bei den Targetmaterialien nach Beispiel 1 und 2 über den betrachteten Wellenlängenbereich hinweg eine niedrigere Reflektivität erzielt (s. Fig. 10), und dies bei vergleichbaren Abscheideraten (s. Fig. 9). Ferner weisen die erfindungsgemäßen Targetmaterialien die oberhalb erläuterten weiteren Vorteile auf. Insbesondere haben sie aufgrund ihrer elektrischen Leitfähigkeit und vorteilhaften Phasenzusammensetzung (Matrixphase; feine Verteilung der Zweitphasen) ein bevorzugtes Sputterverhalten (gleichmäßige Sputterrate unter Vermeidung von Lichtbögen (Arcs) und Partikelbildung), was sich positiv auf die Schichtqualität auswirkt (homogene Schichtzusammensetzung; gleichmäßige Schichtdicke).

### Probenpräparation:

Zur Bestimmung der Volumenanteile der in dem Targetmaterial enthaltenen Phasen und der Dichte des Targetmaterials wurde mittels Trockenpräparation ein metallographischer Schliff aus einem repräsentativen Probenteil hergestellt, indem eine Probe mit einer Fläche von ca. 10-15 × 10-15 mm² im Trockenschnittverfahren (Diamantdrahtsäge, Bandsäge, etc.) zugeschnitten, mittels Druckluft gereinigt, anschließend warm und leitend (C-dotiert) in Phenolharz eingebettet, geschliffen und poliert wurde. Da zumindest der MoOs-Phasenanteil wasserlöslich ist, ist eine Trockenpräparation wichtig. Der so erhaltene Schliff wurde anschließend lichtmikroskopisch analysiert.

### Bestimmung der Phasenanteile mittels Raman- Spektroskopie:

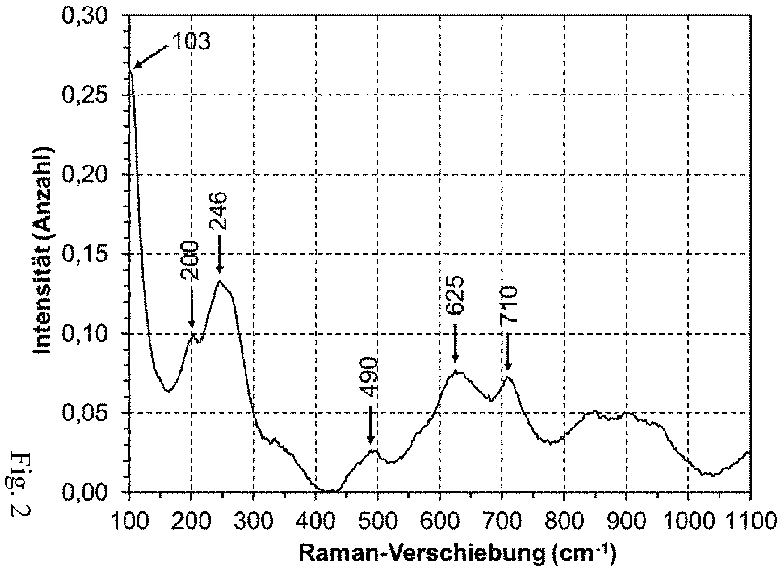

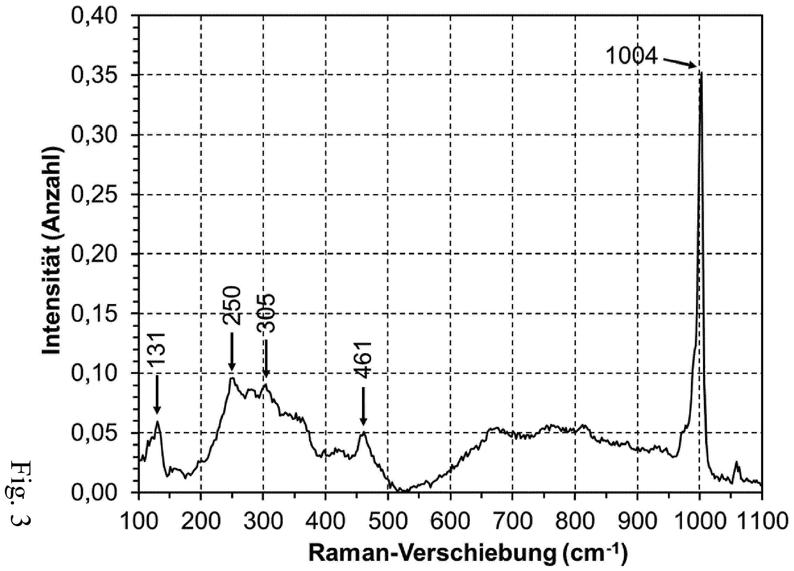

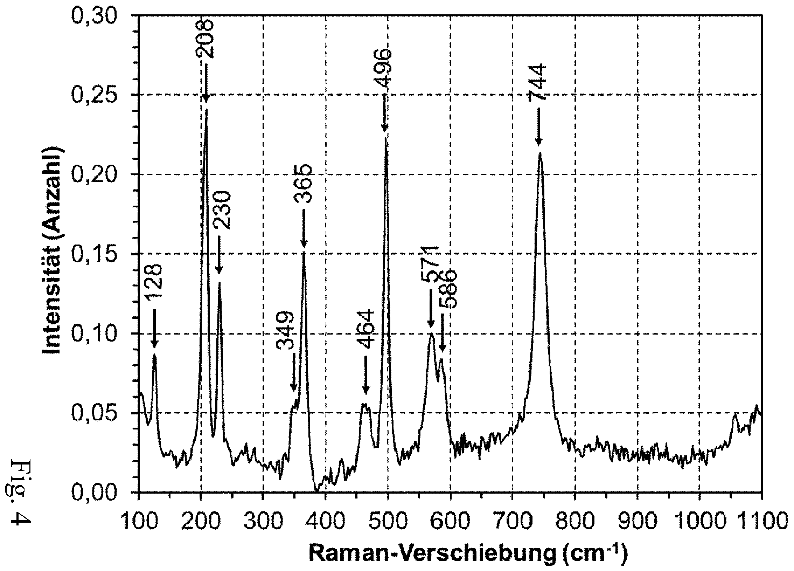

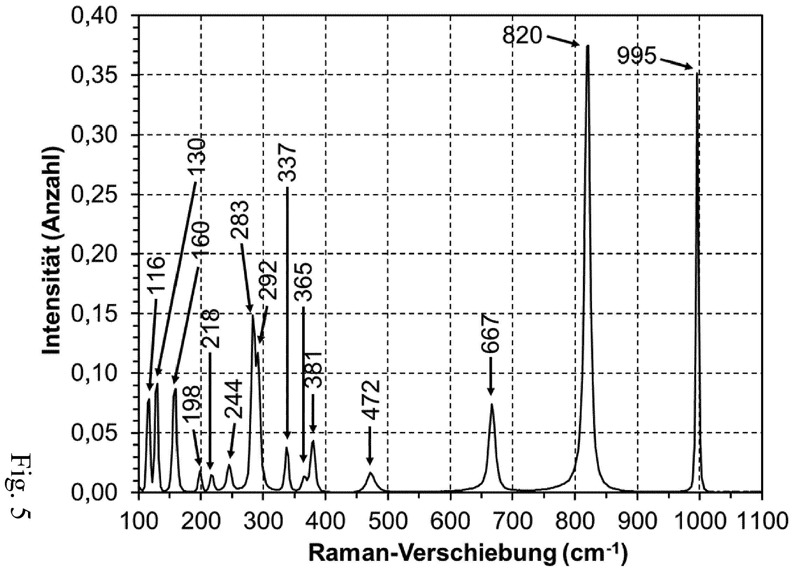

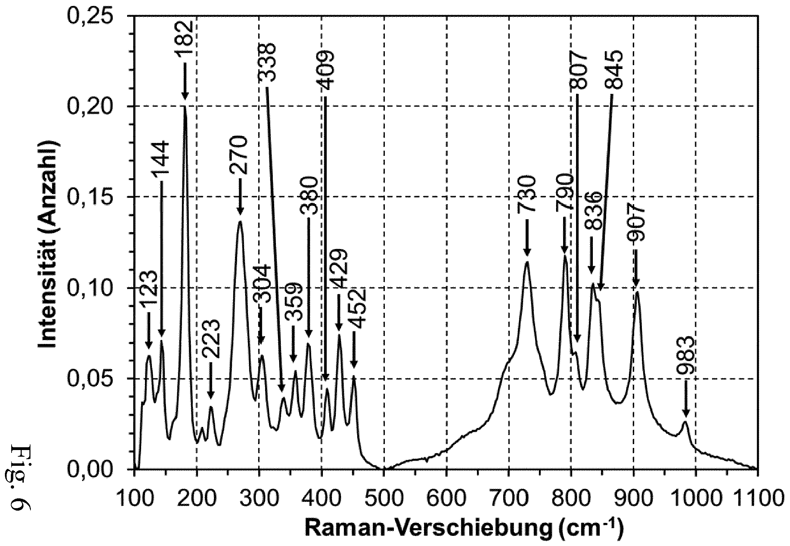

Zur ortsaufgelösten Bestimmung der in dem Targetmaterial enthaltenen Phasen wurde ein Raman-Mikroskop (Horiba LabRAM HR800) verwendet, bei dem ein konfokales Lichtmikroskop (Olympus BX41) mit einem Raman-Spektrometer gekoppelt ist. Die zu analysierende Oberfläche wurde dabei auf einer Fläche von 1 × 1 mm² mit Hilfe eines fokussierten Laserstrahls (He-Ne-Laser, Wellenlänge λ = 632,81 nm, 15 mW Gesamtleistung) Punkt für Punkt mit einer Schrittweite von 5 µm abgerastert (die zu untersuchende Probeoberfläche wurde auf einen motorisierten XYZ-Tisch fixiert und dieser bewegt). Für jeden einzelnen der 201 × 201 Messpunkte wurde ein vollständiges Raman- Spektrum erstellt ("Raman-Mapping"). Raman Spektren werden aus der rückgestreuten Strahlung gewonnen, die über ein optisches Gitter (300 Linien/mm; spektrale Auflösung: 2,6 cm⁻¹) wellenlängendispersiv aufgespalten, und mittels eines CCD-Detektors (1024 × 256 pixel multichannel CCD; Spektralumfang: 200-1050 nm) aufgenommen werden. Bei einem Mikroskop-Objektiv mit 100-facher Vergrößerung und numerischer Apertur NA von 0,9, welches zur Fokussierung des Laserstrahls aus dem Raman-Spektrometer dient, ließ sich eine theoretische Messpunkt-Größe von 0,7 µm² erzielen. Die Anregungsenergiedichte (5 mW/µm²) wird gering genug gewählt um Phasenumwandlungen in der Probe zu vermeiden. Die Eindringtiefe der Anregungsstrahlung ist bei Molybdänoxiden auf einige Mikrometer begrenzt (im Falle von reinem MoOs z.B. auf ca. 4 µm). Pro Messpunkt wurde das Ramansignal über 1 s (s: Sekunde) Akquisitionszeit zeitlich gemittelt, wobei sich ein ausreichend gutes Signal-zu-Rauschverhältnis ergab. Durch automatisierte Auswertung dieser Raman-Spektren (Auswertesoftware Horiba LabSpec 6) wurde eine zweidimensionale Darstellung der Oberflächenzusammensetzung der Probe erstellt, aus der sich quantitativ die Domänengröße, Flächenanteile, etc. der verschiedenen Phasen ermitteln lassen. Zur genauen Identifizierung einer Molybdänoxidphase werden Referenzspektren an zuvor synthetisierten Referenzproben bzw. Referenzspektren an größeren homogenen Probenbereichen aufgenommen, wobei darauf geachtet wird, dass ein Referenzspektrum genau einer Metalloxid-Phase entspricht. In den Fig. 1 bis 6 sind verwendete Referenzspektren von (Mo_{0.93}Ta_{0.07})₅O₁₄ (Fig. 1), Ta₂O₅ (Fig. 2), Mo₁₈O₅₂ (Fig. 3), MoO₂ (Fig. 4), MoOs (Fig. 5), Mo₄O₁₁ (Fig. 6) dargestellt (in den einzelnen Spektren ist die Intensität (Anzahl) des gestreuten Lichts über der Raman-Verschiebung (cm⁻¹) aufgetragen). Die Analyse und Zuordnung der Raman-Spektren erfolgt dabei mit Hilfe des "Multivariante Analysis Modules" der oben genannten Auswertesoftware mittels der CLS-Methode (classical least square fitting). Das Probenspektrum S wird dazu als Linearkombination der einzelnen normalisierten Referenzspektren *Rᵢ* dargestellt, wobei *cᵢ* der jeweilige Gewichtungsfaktor und Δ ein Offsetwert ist, S= Σcᵢ Rᵢ + Δ. Jedem Messpunkt wird anschließend eine Farbe zugeordnet, die einer Metalloxid-Phase entspricht, wobei jeweils nur die Phase mit dem höchsten Gewichtungsfaktor *cᵢ* für die Farbzuordnung verwendet wird. Die Größe (des Betrages) des Gewichtungsfaktors *cᵢ* bestimmt die Helligkeit des Messpunkts. Dieses Vorgehen ist insofern gerechtfertigt, da sich in der Regel das Spektrum von einem Messpunkt eindeutig einer einzigen Metalloxid-Phase zuordnen lässt.

Bei dem verwendeten Objektiv wurde von allen 201 × 201 Messpunkten ein Probenspektrum erhalten, auch wenn auf einer Pore gemessen wurde. In diesem Fall stammte das Signal aus einem unter der Pore liegenden, tieferen Bereich. Falls für einzelne Messpunkte kein Raman-Spektrum erhalten wird, z.B. aufgrund einer Pore, so kann dieses aus der Bestimmung der Flächenanteile ausgenommen werden, d.h. das von den Poren des Targetmaterials eingenommene Volumen ist vom Gesamtvolumen ausgeklammert. Die Volumenangaben der einzelnen Molybdänoxid-Phasen addieren sich daher allein ohne das Porenvolumen auf 100%.

Die hier beschriebene Analysenmethode eignet sich sehr gut zur Bestimmung der relativen Phasenanteile der vorliegend in Frage kommenden Phasen.

### Bestimmung der relativen Dichte:

Die Bestimmung der relativen Dichte des Targetmaterials erfolgt mittels digitaler Bildanalyse von lichtmikroskopischen Bildaufnahmen des metallographischen Schliffs, bei dem der relative Flächenanteil "FA" der Poren ermittelt wird. Dazu erfolgte nach Präparation der Proben eine Bildaufnahme von je drei Hellfeld-Aufnahmen mit einer Größe von 1 × 1mm² mit 100-facher Vergrößerung, wobei Zonen offensichtlicher Ausbrüche oder sonstiger Schadensbilder wie Kratzer aufgrund von Trockenpräparation nach Möglichkeit vermieden wurden. Die erhaltenen Bilder wurden mittels der in der IMAGIC-Bilddatenbank implementierten digitalen Bildverarbeitungssoftware ausgewertet. Dazu wurde am Bild abhängig von der Graustufe der Porenanteil (dunkel) anhand eines Histogramms markiert. Die Untergrenze des Intervalls wurde bei 0 (= schwarz) angesetzt. Demgegenüber muss die Obergrenze subjektiv anhand des Graustufen-Intensitätshistogramms eingeschätzt werden (255 = weiß). Der zu messende Bildbereich wurde eingestellt (ROI), um den Maßstabsbalken auszuschließen. Als Ergebnis erhält man den relativen Flächenanteil "FA" der Poren (in Prozent) und das entsprechend des selektierten Graustufenintervalls eingefärbte Bild (gefärbt bedeutet, dass dieser Pixel in die Messung aufgenommen wurde und demnach als Pore gezählt wurde). Der Wert (1-FA) für die relative Dichte wurde als arithmetisches Mittel aus drei derartigen Porositätsmessungen ermittelt.

## Patentansprüche

1. Sputteringtarget mit einem elektrisch leitfähigen, oxidischen Targetmaterial, wobei das Targetmaterial, nebst Verunreinigungen, aus mindestens einem Metalloxid
- von Molybdän (Mo) als metallischem Hauptbestandteil und
von mindestens einem Dotierungselement M aus der Gruppe Tantal (Ta), Niob (Nb), Vanadium (V) und Titan (Ti) besteht,
**dadurch gekennzeichnet, dass** das Targetmaterial bezogen auf ein Schliffbild desselben - gemessen mit einem Raman-Mikroskop wie in der Beschreibung angegeben - eine Matrixphase aus einem Mischoxid (Mo₁₋ₓMₓ)₅O₁₄ mit 0,01 ≤ x ≤ 0,13 aufweist, wobei M in diesem Mischoxid eines oder mehrere Elemente der Gruppe Tantal (Ta), Niob (Nb), Vanadium (V) und Titan (Ti) ist, wobei in dem Targetmaterial die Matrixphase aus dem Mischoxid bezogen auf ein Schliffbild des Targetmaterials - gemessen mit einem Raman-Mikroskop wie in der Beschreibung angegeben- einen Anteil von 100 Vol.% aufweist oder einen Anteil von ≥ 60 Vol.% aufweist und das Targetmaterial zudem aus
a. MoO₂ und Mo₄O₁₁, sowie
b. optional einer oder mehrerer Verbindung(en) aus der Gruppe:
- MoO₃,
- weiterer substöchiometrischer Molybdänoxide aus der Gruppe Mo₁₇O₄₇, Mo₅O₁₄, Mo₈O₂₃, Mo₉O₂₆ und Mo₁₈O₅₂,
- stöchiometrischer und/oder substöchiometrischer Ta-Oxid(e),
- stöchiometrischer und/oder substöchiometrischer Nb-Oxid(e),
- stöchiometrischer und/oder substöchiometrischer V-Oxid(e), und
- stöchiometrischer und/oder substöchiometrischer Ti-Oxid(e),
als eine oder mehrere Zweitphasen, die als Inseln in der Matrixphase verteilt sind, besteht, wobei diese Zweitphasen bezogen auf ein Schliffbild des Targetmaterials - gemessen mit einem Raman-Mikroskop wie in der Beschreibung angegeben - in Summe einen Anteil ≤ 40 Vol.% bilden, wobei in dem Targetmaterial bezogen auf ein Schliffbild desselben - gemessen mit einem Raman-Mikroskop wie in der Beschreibung angegeben- der Anteil der Zweitphase MoOs im Bereich von 0 - 2 Vol.% liegt, wobei in dem Targetmaterial der Sauerstoff-Gehalt in Gew.%, mittels Trägergasheißextraktion ermittelt, im Bereich von 26 bis 32 Gew.% liegt und wobei in dem Targetmaterial der Anteil des Dotierungselements M in at.% relativ zu dem Gesamtgehalt an Mo und dem Dotierungselement M in at.% in Summe in dem Bereich von 0,02 - 0,15 liegt.

2. Sputteringtarget gemäß Anspruch 1, **dadurch gekennzeichnet, dass** in dem Targetmaterial das Dotierungselement M durch Ta gebildet wird und die Matrixphase aus dem Mischoxid (Mo₁₋ₓTaₓ)₅O₁₄mit 0,06 ≤ x ≤ 0,08 gebildet wird.

3. Sputteringtarget gemäß Anspruch 2, **dadurch gekennzeichnet, dass** in dem Targetmaterial das Dotierungselement Ta vollständig als Metalloxid vorliegt, wobei in dem Targetmaterial bezogen auf ein Schliffbild desselben - gemessen mit einem Raman-Mikroskop - der Anteil der Phase Ta₂O₅ ≤ 3 Vol.% ist.

4. Sputteringtarget gemäß einem der Ansprüche 1 bis 3 **dadurch gekennzeichnet, dass** in dem Targetmaterial das Dotierungselement M durch Nb gebildet wird und die Matrixphase aus dem Mischoxid (Mo₁₋ₓNbₓ)₅O₁₄ mit 0,07 ≤ x ≤ 0,12 gebildet wird.

5. Sputteringtarget gemäß Anspruch 4, **dadurch gekennzeichnet, dass** in dem Targetmaterial das Dotierungselement Nb vollständig als Metalloxid vorliegt, wobei in dem Targetmaterial bezogen auf ein Schliffbild desselben - gemessen mit einem Raman-Mikroskop - der Anteil der Phase Nb₂O₅ ≤ 3 Vol.% ist.

6. Sputteringtarget gemäß einem der vorangehenden Ansprüche, **dadurch gekennzeichnet, dass** das Targetmaterial eine relative Dichte von ≥ 95% und eine elektrische Leitfähigkeit von ≥ 100 S/m bei 25°C aufweist.

7. Sputteringtarget gemäß einem der vorangehenden Ansprüche, **dadurch gekennzeichnet, dass** das Targetmaterial als ein pulvermetallurgisch hergestellter Festkörper vorliegt.

8. Sputteringtarget gemäß einem der vorangehenden Ansprüche, **dadurch gekennzeichnet, dass** in dem Targetmaterial bezogen auf ein Schliffbild desselben - gemessen mit einem Raman-Mikroskop - in der Matrixphase eine oder mehrere Zweitphasen als fein und gleichmäßig verteilte, kleine Inseln ausgebildet sind.

9. Verwendung eines Sputteringtargets nach einem der Ansprüche 1 bis 8 zur Gasphasen-Abscheidung einer molybdänoxidhaltigen Schicht, **dadurch gekennzeichnet, dass** das Sputterverfahren als DC-Sputterverfahren bzw. gepulstes DC-Sputterverfahren in einer Edelgasatmosphäre ohne Sauerstoff oder alternativ unter Zufuhr von höchstens 20 Vol.% Sauerstoff als Reaktivgas erfolgt.

## Claims

1. Sputtering target comprising an electrically conductive, oxidic target material, where the target material consists, together with impurities, of at least one metal oxide
- of molybdenum (Mo) as metallic main constituent, and of at least one doping element M from the group consisting of tantalum (Ta), niobium (Nb), vanadium (V) and titanium (Ti), **characterized in that** the target material comprises, based on a polished section thereof - measured using a Raman microscope as indicated in the description - a matrix phase composed of a mixed oxide (Mo₁₋ₓMₓ)₅O₁₄ where 0.01 ≤ x ≤ 0.13, where M in this mixed oxide is one or more elements from the group consisting of tantalum (Ta), niobium (Nb), vanadium (V) and titanium (Ti), wherein the matrix phase composed of the mixed oxide in the target material has, based on a polished section of the target material - measured using a Raman microscope as indicated in the description - a proportion of 100% or a proportion of ≥ 60% by volume and the target material consists furthermore of
a. MoO₂ and Mo₄O₁₁ and also
b. optionally one or more compound(s) from the group consisting of:
- MoO₃,
- further substoichiometric molybdenum oxides from the group consisting of
Mo₁₇O₄₇, Mo₅O₁₄, Mo₈O₂₃, Mo₉O₂₆ and Mo₁₈O₅₂,
- stoichiometric and/or substoichiometric Ta oxide(s),
- stoichiometric and/or substoichiometric Nb oxide(s),
- stoichiometric and/or substoichiometric V oxide(s), and
- stoichiometric and/or substoichiometric Ti oxide(s),
as one or more second phases which are distributed as islands in the matrix phase, with these second phases forming, based on a polished section of the target material and measured using a Raman microscope as indicated in the description, a total proportion of ≤ 40% by volume, wherein the proportion of the second phase MoOs in the target material is, based on a polished section of the target material - measured using a Raman microscope as indicated in the description - in the range 0 - 2% by volume, wherein the oxygen content in % by weight and determined by carrier gas hot extraction the target material is in the range from 26 to 32% by weight and wherein the total proportion of the doping element M in at.% in the target material relative to the total content of Mo and the doping element M in at.% is in the range 0.02 - 0.15.

2. Sputtering target according to claim 1, **characterized in that**, in the target material, the doping element M is formed by Ta and the matrix phase is formed by the mixed oxide (Mo₁₋ₓTaₓ)₆O₁₄ where 0.06 ≤ x ≤ 0.08.

3. Sputtering target according to claim 2, **characterized in that** the doping element Ta is entirely present as metal oxide in the target material, where the proportion of the phase Ta₂O₅ in the target material is, based on a polished section thereof and measured using a Raman microscope, ≤ 3% by volume.

4. Sputtering target according to any of claims 1 to 3, **characterized in that**, in the target material, the doping element M is formed by Nb and the matrix phase is formed by the mixed oxide (Mo₁₋ₓNbₓ)₅O₁₄ where 0.07 ≤ x ≤ 0.12.

5. Sputtering target according to claim 4, **characterized in that** the doping element Nb is entirely present as metal oxide in the target material, where the proportion of the phase Nb₂O₅ in the target material is, based on a polished section thereof and measured using a Raman microscope, ≤ 3% by volume.

6. Sputtering target according to any of the preceding claims, **characterized in that** the target material has a relative density of ≥ 95% and an electrical conductivity of ≥ 100 S/m at 25°C.

7. Sputtering target according to any of the preceding claims, **characterized in that** the target material is present as a powder-metallurgically produced solid body.

8. Sputtering target according to any of the preceding claims, **characterized in that** one or more second phases are present as finely and uniformly dispersed, small islands in the matrix phase in the target material, based on a polished section thereof and measured using a Raman microscope.

9. Use of a sputtering target according to any of claims 1 to 8 for vapour deposition of a molybdenum oxide-containing layer, **characterized in that** the sputtering process is carried out as DC sputtering process or pulsed DC sputtering process in a noble gas atmosphere without oxygen or alternatively with introduction of not more than 20% by volume of oxygen as reactive gas.

## Revendications

1. Cible de pulvérisation cathodique comportant un matériau cible conducteur de l'électricité, de type oxyde, le matériau cible étant constitué, outre d'impuretés, d'au moins un oxyde métallique
- du molybdène (Mo) en tant que constituant principal métallique, et
d'au moins un élément dopant M du groupe tantale (Ta), niobium (Nb), vanadium (V) et titane (Ti),
**caractérisée en ce que** le matériau cible comprend, par rapport à une micrographie de ce dernier - mesurée à l'aide d'un microscope Raman comme indiqué dans la description - une phase matricielle constituée d'un oxyde mixte (Mo₁₋ₓMₓ) ₅O₁₄, avec 0,01 ≤ x ≤ 0,13, M étant, dans cet oxyde mixte, un ou plusieurs éléments du groupe tantale (Ta), niobium (Nb), vanadium (V) et titane (Ti), la phase matricielle constituée de l'oxyde mixte présentant, par rapport à une micrographie du matériau cible - mesurée à l'aide d'un microscope Raman comme indiqué dans la description - une proportion de 100 % en volume, ou présentant une proportion ≥ 60 % en volume, et le matériau cible étant en outre constitué
a. de MoO₂ et de Mo₄O₁₁, ainsi que
b. éventuellement d'un ou plusieurs composés du groupe :
- MoO₃,
- autres oxydes de molybdène sous-stœchiométriques du groupe MO₁₇O₄₇, Mo₅O₁₄, Mo₈O₂₃, Mo₉O₂₆ et Mo₁₈O₅₂,
- d'un ou plusieurs oxydes de Ta stoechiométriques et/ou sous-stoechiométriques,
- d'un ou plusieurs oxydes de Nb stoechiométriques et/ou sous-stoechiométriques,
- d'un ou plusieurs oxydes de V stoechiométriques et/ou sous-stoechiométriques, et
- d'un ou plusieurs oxydes de Ti stoechiométriques et/ou sous-stoechiométriques,
sous forme d'une ou plusieurs phases secondaires, qui sont réparties sous forme d'îlots dans la phase matricielle, ces phases secondaires formant en tout une proportion ≤ 40 % en volume par rapport à une micrographie du matériau cible - mesurée à l'aide d'un microscope Raman tel qu'indiqué dans la description -, la proportion de la phase secondaire MoO₃ étant comprise dans la plage de 0 à 2 % en volume dans le matériau cible, par rapport à une micrographie de ce dernier - mesurée à l'aide d'un microscope Raman comme indiqué dans la description -,
la teneur en oxygène du matériau cible, en % en poids, déterminée par extraction par gaz inerte, étant dans la plage de 26 à 32 %, et la proportion de l'élément dopant M en % at, par rapport à la teneur totale en Mo et en l'élément dopant M dans le matériau cible, étant, en % at, au total dans la plage de 0,02 à 0,15.

2. Cible de pulvérisation cathodique selon la revendication 1, **caractérisée en ce que** dans le matériau cible, l'élément dopant M est formé par Ta, et la phase matricielle est formée à partir de l'oxyde mixte (Mo₁₋ₓTaₓ)₅O₁₄, avec 0,06 ≤ x ≤ 0,08.

3. Cible de pulvérisation cathodique selon la revendication 2, **caractérisée en ce que** dans le matériau cible, l'élément dopant Ta se présente en totalité sous forme d'un oxyde métallique, la proportion de la phase Ta₂O₅ étant ≤ 3 % en volume, par rapport à une micrographie de ce dernier - mesurée à l'aide d'un microscope Raman -.

4. Cible de pulvérisation cathodique selon l'une des revendications 1 à 3, **caractérisée en ce que** dans le matériau cible, l'élément dopant M est formé par Nb et la phase matricielle est formée à partir de l'oxyde mixte (Mo₁₋ₓNbₓ)₅O₁₄, avec 0,07 ≤ x ≤ 0,12.

5. Cible de pulvérisation cathodique selon la revendication 4, **caractérisée en ce que** dans le matériau cible, l'élément dopant Nb se présente complètement sous forme d'un oxyde métallique, la proportion de la phase Nb₂O₅ étant ≤ 3 % en volume dans le matériau cible, par rapport à une micrographie de ce dernier - mesurée à l'aide d'un microscope Raman -.

6. Cible de pulvérisation cathodique selon l'une des revendications précédentes, **caractérisée en ce que** le matériau cible présente une densité relative ≥ 95 % et une conductivité électrique ≥ 100 S/m à 25 °C.

7. Cible de pulvérisation cathodique selon l'une des revendications précédentes, **caractérisée en ce que** le matériau cible se présente sous forme d'un solide fabriqué par la métallurgie des poudres.

8. Cible de pulvérisation cathodique selon l'une des revendications précédentes, **caractérisée en ce que**, dans le matériau cible, il y a, par rapport à la micrographie de ce dernier - mesurée à l'aide d'un microscope Raman - , formation, dans la phase matricielle, d'une ou plusieurs phases secondaires sous forme de petits îlots fins et uniformément répartis.

9. Utilisation d'une cible de pulvérisation cathodique selon l'une des revendications 1 à 8 pour le dépôt en phase gazeuse d'une couche contenant un oxyde de molybdène, **caractérisée en ce que** le procédé de pulvérisation cathodique est mis en oeuvre sous forme d'un procédé de pulvérisation cathodique CC ou d'un procédé de pulvérisation cathodique CC pulsé dans une atmosphère de gaz noble sans oxygène, ou encore, en alternance, avec apport d'au plus 20 % en volume d'oxygène en tant que gaz réactif.
